# EUROPEAN PATENT APPLICATION

(11) **EP 2 003 944 A2**
(43) Date of publication of application: **17.12.2008**
(21) Application number: 07737855.2
(22) Date of filing: 06.03.2007
(51) Int. Cl.: H05K 7/20, F28D 15/02, H01L 23/427

(54) **METHOD OF EBULLIENT COOLING, EBULLIENT COOLING APPARATUS, FLOW CHANNEL STRUCTURE AND APPLICATION PRODUCT THEREOF**

(30) Priority: 06.03.2006 JP 2006059840; 31.08.2006 JP 2006236404
(71) Applicant: Tokyo University Of Science Educational Foundation Administrative Organization, Shinjuku-ku Tokyo 162-8601 (JP)
(72) Inventor: SUZUKI, Koichi, Tokyo 162-8601 (JP); GOTO, Yosuke, Tano-gun Gunma 370-2107 (JP)
(74) Representative: Grünecker, Kinkeldey, Stockmair & Schwanhäusser Anwaltssozietät
(86) International application number: PCT/JP2007/054308
(87) International publication number: WO 2007/102498

(57) **Abstract**

The invention provides a boil cooling method, a boil cooling apparatus, a flow channel structure, and applied products thereof, by which noise and vibration attending on cooling by microbubble emission boiling can be effectively reduced, and efficient boil cooling can be realized.

A subcooled cooling liquid is caused to flow through a flow channel structure, which is formed by using a surface of an object 10 to be cooled as a surface 10A to be cooled and the surface 10A to be cooled as a tubular wall and has a tubular flow channel 16, through which the subcooled cooling liquid is caused to flow, and a structure that a group of rigid needles N1, N2, ·· Ni ·· is protruded within the tubular flow channel 16 from the tubular wall of the tubular flow channel, thereby conducting cooling by microbubble emission boiling.

## Description

### TECHNICAL FIELD

The present invention relates to a boil cooling method, a boil cooling apparatus for carrying out the boil cooling method, a flow channel structure used in this boil cooling apparatus, and applied products to which these method, apparatus and structure are applied.

### BACKGROUND ART

When a liquid is heated, its temperature is gradually raised and lastly reached "a saturation temperature" that the liquid temperature does not rise any more. When the liquid is further heated, "vaporization of the liquid" occurs in the interior of the liquid. This state is called boiling, and the saturation temperature is called a boiling point.

The liquid temperature is raised in the boiled state, and the energy applied to the liquid by the heating is consumed for "vaporization of the liquid in the interior of the liquid". This thermal energy is called "latent heat". The latent heat is extremely large compared with the thermal energy for raising the temperature of the liquid. Accordingly, boiling of a liquid is utilizing, whereby a large quantity of heat can be taken out of a substance heated to a high temperature to achieve a great cooling effect. Venturing to say, this can be understood from the fact that 420 kJ of heat is required when 1 kg (1 liter) of water is heated from 0°C to 100°C that is the saturation temperature thereof, while 2,256 kJ of heat (latent heat) is require when all the water is turned into vapor.

Cooling utilizing boiling is called "boil cooling", and various boil cooling apparatus have heretofore been proposed.

For example, there has been proposed a boil cooling apparatus of an immersion system, which has a container containing a cooling liquid and a pipe going through the cooling liquid, and in which a semiconductor element as an object to be cooled is immersed in the cooling liquid, and "a liquid having a boiling point lower than the cooling liquid" is circulated in the pipe (for example, Patent Art. 1).

A boiling phenomenon generally follows such a passage as described below.

"A heating block" composed of, for example, a metal is immersed in a liquid, and the heating block is heated to raise the temperature of a heat-transfer surface thereof. "The heat-transfer surface" is "a surface coming into contact with the liquid" of the heating block, and the temperature thereof is "the temperature of the heat-transfer surface".

When the temperature of the heat-transfer surface rises to a certain extent, "minutes bubbles (primary bubbles) about 1 mm or smaller in size" are generated at the heat-transfer surface of the heating block. This state is "a state that the temperature of a liquid layer portion of the liquid coming into contact with the heat-transfer surface that is a surface of the heating black has reached a saturation temperature, and boiling is occurring at a portion of the heat-transfer surface.

Physical quantities expressing the cooling effect by the boiling of the liquid include "a heat flux". Venturing to say in the context of the example in the description, the heat flux is "a quantity of heat transferred to the liquid per unit time through the unit area of the surface (the "heat-transfer surface") of the heating block coming into contact with the liquid", and represented by a unit of W/cm² or W/m². The quantity of heat removed is greater, and the cooling effect is greater as the heat flux is greater.

When the microbubbles generate at the heat-transfer surface of the heating block, "the increase rate of the heat flux" increases. When the heating of the heating block is further continued, the amount of primary bubbles generated at the heat-transfer surface also increases, and the bubbles coalesce with one another and grow repeatedly, thereby creating a state that the surface of the heating block has been covered with "a large bubble".

In other words, when the amount of minutes bubbles generated at the heat-transfer surface increases, the bubbles generated coalesce with one another and grow to "a large bubble" of several centimeters though it varies with the size of the heat-transfer surface. The bubble greatly grown in such a manner is "such a bubble thin in thickness as squashed". When such a large bubble adhere to the surface of the heating block, the boiling is inhibited because the heating block is not in direct contact with the liquid at a portion to which the large blocks have adhered, so that increase in heat flux is stopped to reach maximum.

In other words, the large bubble (hereinafter also referred to as "coalesced bubble" formed by the coalescence of the small bubbles and gradual growth soon cover the surface of the solid to prevent permeation of the liquid and inhibit the boiling. However, heat transferred to the liquid from a surface to be cooled becomes maximum, and the heat flux at this time is said as "critical heat flux" and represented by a heat flux (W/cm² or W/m²) transferred per unit time. The critical heat flux is called "critical heat flux" in English, and "CHF" taken from the first letters of the words is widely used in the field of heat transfer with boiling.

When the heating block is heated even after the heat flux reaches the critical heat flux, the heat-transfer surface starts to be dried at the portion where the large bubble has been in contact with the heat-transfer surface, and the heat flux rapidly reduces with the rapid temperature rise of the heat-transfer surface, so that the cooling effect is rapidly lowered. When the heating is further continued, the heat-transfer surface is completely dried at the portion covered with the large bubble, and this portion turns into "a state covered with a thin vapor film".

The thermal energy of the heating block is transferred as radiant heat to the liquid at this dried portion, and the heat flux starts to be increased again. However, the temperature of the heat-transfer surface becomes high because the heat-transfer surface is in no contact with the liquid, and the heat-transfer surface is burnt out if this temperature exceeds the melting point of the heating block.

The boiling form until the heat flux reaches the critical heat flux from the state that the microbubbles have started to be generated at the heat-transfer surface of the heating block is called "nucleate boiling", and the boiling form until the heat flux decreases and starts to be increased again from the state of the critical heat flux, and the boiling form after the change in the heat flux has started to be increased again at the state that the heat-transfer surface has been covered with the thin vapor film and dried are called "transition boiling" and "film boiling", respectively.

In other words, when the heating block immersed in the liquid is continuously heated, the boiling forms of nucleate boiling, transition boiling and film boiling appear in that order, and the heating block is finally led to burning-out.

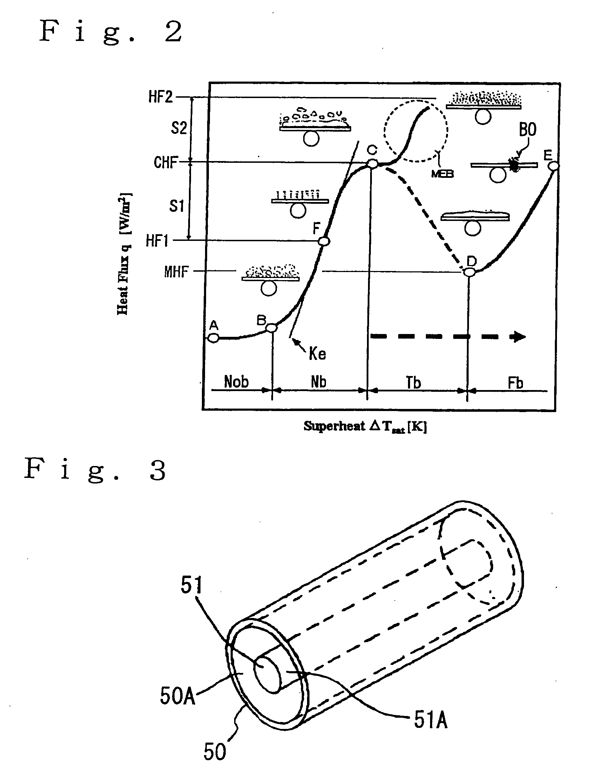

Since "the process leading to burning-out through the film boiling from the transition boiling" after the critical heat flux has been reached is generally extremely rapidly occurs, and it is very difficult to control the process (illustrated by a broken-line arrow in FIG. 2), the process has been scarcely used in cooling of electronic devices though there have been examples of cooling by nucleate boiling.

Single-phase natural convection and forced convection of air or a cooling liquid have heretofore been mainly used in cooling of electronic devices, and the limitation of heat removal thereof is said to be about 100 W/cₘ² (1 MW/m²) .

It has been reported that when a cooling liquid is supplied to a surface (heat-transfer surface) to be cooled of an object to be cooled after being subcooled to "a temperature lower than the saturation temperature" in advance in the case where the boil cooling is conducted while causing the cooling liquid to flow along the surface to be cooled, good boil cooling can be realized while retaining the nucleate boiling form up to a considerably high temperature region without causing "shifting to the transition boiling" in a certain flow channel range from an end of the surface to be cooled, at which cooling is started (Non-Patent Art. 1).

When the boil cooling is conducted while causing the cooling liquid to flow along the surface to be cooled, heat from the surface to be cooled rapidly raises the temperature of the cooling liquid coming into contact with the surface to be cooled up to the saturation temperature and then causes boiling when the cooling liquid is subcooled, and minutes bubbles generated coalesce with one another and grow to create a state covering the surface to be cooled. The cooling liquid in the subcooled state, i.e., the cooling liquid lower in temperature than the saturation temperature (the cooling liquid thus subcooled is referred to as "the subcooled liquid") flows in a region outside "the coalesced bubble".

Such "subcooled liquid flowing outside the grown and coalesced bubble" lowers the temperature of the coalesced bubble to "collapse it into "minutes bubbles", i.e., condense and collapse the coalesced bubble. Since the cooling liquid is supplied again to the heat-transfer surface covered with bubbles when the coalesced bubble is collapsed in such a manner, cooling by nucleate boiling is conducted again without being shifted to the transition boiling. Since this process is repeated during 1 second, the heat flux can be "made higher than the ordinary critical heat flux".

The temperature of the heat-transfer surface lowers in a moment that solid-liquid contact has occurred. Since temperature change is not followed in a short period of time from the viewpoint of measurement, however, this phenomenon apparently occurs in "transition boiling", and is called "microbubble emission boiling" (this is one mechanism form of the microbubble emission boiling, and details thereof are not yet clarified).

As described above, the microbubble emission boiling using the subcooled liquid is utilized, whereby "a larger quantity of heat" can be transferred from the heat-transfer surface to the cooling liquid, and heat flux higher than the critical heat flux can be obtained.

When the process of the boiling form causing "microbubble emission boiling" is described collectively, the temperature of the surface to be cooled covered with the coalesced bubble is usually raised to start drying, thereby shifting to the transition boiling. However, the bubble generated in the subcooled liquid is condensed and collapsed, and the liquid is supplied again to start boiling, so that "bubble collapse-liquid supply-bubble growth-critical heat flux-bubble collapse" is repeated in a short period of time (for example, 20 to 90 times in 1 second) according to the experimental result by the present inventors. As a result, heat can be removed by high heat flux exceeding the ordinary critical heat flux.

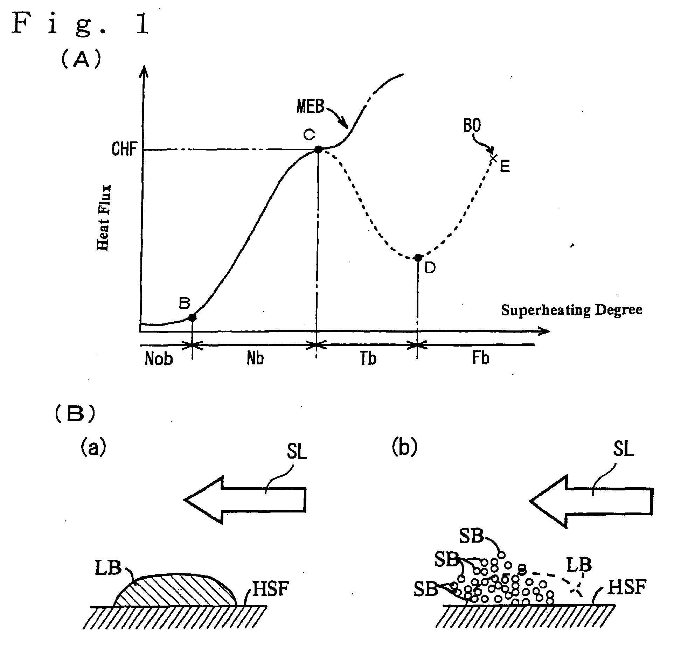

FIG. 1(A) is a conceptual view illustrating a comparison of a boiling curve including microbubble emission boiling with limitation of heat removal as to the boil cooling described above.

An axis of abscissa indicates a superheating degree (a difference between the saturation temperature of a cooling liquid and the temperature of a surface to be cooled), and an axis of ordinate indicates a heat flux. When the superheating degree of the surface to be cooled is increased, heat of the surface to be cooled first is consumed for raising the temperature of the cooling liquid in "a non-boiling region (Nob)", and the heat flux is rapidly increased by boiling of the cooling liquid in "a nucleate boiling region (Nb)" to reach a critical heat flux (CHF, point C).

For example, when subcooled water at 40 K and 1 atm is caused to flow at 0.5 m/sec, a critical heat flux of about 300 W/cm² (3 MW/m²) is reached.

In ordinary boiling, "a transition boiling region (Tb)" indicated by a broken line follows the nucleate boiling region, in which the critical heat flux has been reached, and the heat flux is rapidly decreased to be shifted to "a film boiling region (Fb)", where the heat flux is increased again to finally lead to "burning-out of the surface to be cooled (BO, point E).

On the other hand, the heat flux can be further increased beyond the critical heat flux (CHF) by conducting "microbubble emission boiling (MEB)" after the critical heat flux by "collapsing the grown and coalesced bubble into microbubbles" using the subcooled liquid.

In other words, the coalesced bubble greatly grown at the critical heat flux (CHF) by the microbubble emission boiling is condensed and collapsed into a group of microbubbles in the transition boiling region to increase the heat flux beyond CHF.

FIG. 1(B)(a) illustrates a state that a coalesced bubble (LB) greatly grown by coalescence has adhered to a heat-transfer surface HSF, and FIG. 1(B)(b) illustrates a state that the coalesced bubble LB has been collapsed into a group of microbubbles by the flow of the subcooled liquid SL. Cooling utilizing the microbubble emission boiling in such a manner is called "cooling by microbubble emission boiling".

FIG. 2 is a diagram for easily understanding and explaining the contents illustrated in FIG. 1(A) in detail. In FIG. 2, a laterally slender shape indicates a surface to be cooled, a substantially circular shape under that indicates a heating source, and bubbles in each stage are typically illustrated on the surface to be cooled so as to easily understand an image.

In FIG. 2, characters S1, S2, MHF and Ke indicate conventional margin of safety represented by a difference between normal limitation HF1 of heat removal and critical heat flux CHF, margin of safety in microbubble emission boiling represented by a difference between limitation HF2 of heat removal by microbubble emission boiling and critical heat flux CHF, a minimum value of the heat flux after reaching the critical heat flux, and the Kutateladze's equation, respectively.

Accordingly, for example, when subcooled water at 40 K and 1 atm is caused to flow at 0.5 m/sec on a short surface to be cooled having a length of about 5 cm in a flow direction of the subcooled liquid to "collapse a coalesced bubble grown into microbubbles", a heat flux (limitation HF2 of heat removal by microbubble emission boiling) of 400 W/cm² (4 MW/m²) or more, particularly 450 to 1,000 400 W/cm² can be obtained, and the heat flux obtained comes nearer to 1,000 W/cm² as the length of the surface to be cooled is shorter. Incidentally, normal limitation HF1 of heat removal is about 100 W/cm².

However, when the cooling by microbubble emission boiling is conducted by using the subcooled cooling liquid, a problem that the temperature of the cooling liquid is gradually raised as the cooling liquid is caused to flow along the surface to be cooled, and so the effect by subcooling is reduced as the cooling liquid goes nearer to the downstream side of a flow channel is involved.

In addition, as another great problem in the cooling by microbubble emission boiling with the subcooled liquid, there is a problem that high "noise and vibration" occur due to high change in pressure attending on collapse of the coalesced bubble greatly grown.

In other words, when the cooling by microbubble emission boiling is conducted by causing the subcooled liquid to flow in a flow channel for cooling, great vibration and noise occur repeatedly at a flow channel portion of the cooling liquid, which forms an inhibition factor against the practical use of the cooling by microbubble emission boiling.

Various attempts have been proposed for obtaining a high heat flux. However, any proposal does not carry out an investigation as to the prevention of "noise and vibration".

For example, a cooling apparatus aiming at a high cooling efficiency by quickly extinguishing boiling bubbles by using a nozzle has been proposed (for example, Patent Art. 2).

The apparatus disclosed in Patent Art. 2 is a cooling apparatus mainly aiming at a semiconductor device as "an object of cooling", and conducting cooling by using 2 kinds of nozzles, injecting a low-temperature refrigerant liquid from a first nozzle toward a heat-generating body to generate boiling bubbles by heat of the heat-generating body, thereby forming a high-temperature refrigerant liquid in "a vapor-liquid two phase state", and injecting the same low-temperature refrigerant liquid from a second nozzle toward the high-temperature refrigerant liquid to quench the high-temperature refrigerant liquid, thereby condensing and extinguishing the boiling bubbles.

According to this cooling system, it is considered to obtain "a heat flux of about 200 W/cm² in a temperature range of about 120°C", and the system aims at cooling of a short heat-transfer surface such as a semiconductor device. However, Patent Art. 2 does not describe anything about "noise and vibration" and thus does not refer to the countermeasure thereof.

As a boil cooling method, has been proposed a method aiming at a high heat flux by forming a secondary flow channel to a flow channel, through which a refrigerant (cooling liquid) is caused to flow, through a partition wall, also causing the refrigerant to flow through the secondary flow channel, and supplying the refrigerant from the side of the secondary flow channel through "a supply hole provided in the partition wall" to lower the temperature of the refrigerant raised in temperature, thereby condensing and collapsing "growing bubbles" to conduct "division of the bubbles" (for example, Patent Art. 3).

Even in the case of this method, it is considered to cause considerably great noise and vibration attending on condensation and collapse of the coalesced bubble greatly grown. However, this article does not refer to noise and vibration.

Incidentally, "cooling by microbubble emission boiling" is characterized by condensing and collapsing the coalesced bubble covering the surface to be cooled and coming into contact with the surface to be cooled by the subcooled liquid. According to the cooling method described in Patent Art. 3, however, the coalesced bubble separated from the surface to be cooled or coming into no contact with the surface to be cooled is collapsed, and this has no cooling effect by boiling and is different from "microbubble emission boiling".

As described above, there has not been yet proposed an effective measure for solving the noise and vibration attending on the collapse of the coalesced bubble in the conventionally proposed boil cooling methods.

On the other hand, when water is heated by an electric heater in an electric water heater, though it does not belong to the field of "boil cooling", water is boiled about the electric heater to form bubbles of steam, and noise is made upon the growth and collapse of the bubbles. In order to reduce this noise, there has been proposed a method for reducing the noise by providing irregularities, grooves, projections or the like on the surface of the electric heater itself to "control bubbles generated to a small size" (for example, Patent Art. 4).

However, the proposal of Patent Art. 4 cannot be applied to the reduction of noise and vibration attending on the collapse of the coalesced bubble in the cooling by microbubble emission boiling even if the growth of bubbles can be effectively controlled in a region of a small heat flux such as a nucleate boiling region, since "a great heat flux is realized by collapsing the coalesced bubble in a region generating the coalesced bubble" in the cooling by microbubble emission boiling that conducts high heat flux cooling.
Patent Art. 1: Japanese Patent Application Laid-Open No. 61-54654
Patent Art. 2: Japanese Patent Application Laid-Open No. 5-136305
Patent Art. 3: Japanese Patent Application Laid-Open No. 2005-79337
Patent Art. 4: Japanese Patent Application Laid-Open No. 2000-329406
Non-Patent Art. 1: "Subcooled Flow Boiling Accompanied by Microbubble Emission" (Proceedings of The 41th National Heat Transfer Symposium (June, 2004), Vol. 1, pp. 19-20)

### DISCLOSURE OF THE INVENTION

In view of the foregoing circumstances, it is an object of the present invention to effectively reduce noise and vibration attending on cooling by microbubble emission boiling that conducts high heat flux cooling, thereby efficiently realizing boil cooling.

Another object of the present invention is to reduce lowering of a cooling effect attending on temperature rise of a cooling liquid on the downstream side of a cooling liquid flow in cooling by microbubble emission boiling.

The present inventors have carried out an extensive investigation with a view toward achieving the above objects. As a result, it has been confirmed that when the condition of noise and vibration is observed, rapid increase in vibration or pressure occurs periodically and just after collapse of a coalesced bubble, and a high air pressure is generated when the whole coalesced bubble is collapsed at a time, which forms a cause of noise and vibration, and experiments have been conducted repeatedly. As a result, it has been confirmed that when a group of rigid needles is provided on an inner wall of a tubular flow channel, an air pressure generated can be reduced without collapsing the coalesced bubble at a time, thus leading to completion of the present invention. The reason for this is not clearly known, but it is conjectured that when bubbles are grown up to a critical heat flux to form a coalesced bubble, and the coalesced bubble comes into contact with individual rigid needles making up the group of rigid needles, a small recess or concave part is formed by a surface tension at a contact portion between each rigid needle and the coalesced bubble, thereby enlarging a surface area of the bubble, i.e., increasing a contact area with the cooling liquid to make the bubble more collapsible, the recess or concave part of the rigid needle then becomes a starting point of collapse to start collapsing the coalesced bubble at the recess or concave part of the rigid needle cooled to almost a temperature of the cooling liquid to form a chain for collapsing portions in no contact with the rigid needle, and the respective rigid needles fulfill such same function as a bubble collapse-dividing means to divide the collapse of the coalesced bubble, not at a time, so that the effect to reduce the air pressure generated is brought about.

When the mechanism for collapsing the coalesced bubble according to the present invention is conjectured from another point of view, a subcooled liquid enters the coalesced bubble at the contact surface with the needle to form a liquid film. In this case, it is considered that force to lift up the liquid by the pressure within the coalesced bubble is balanced with the surface tension of the contact surface working downward.

The heat of the coalesced bubble is first transferred to the metal needle at a temperature equal to or lower than the temperature of the subcooled liquid through the liquid film good in thermal conductivity rather than transferred to the liquid from a vapor-liquid interface. As a result, it is considered that the condensation and collapse start from the contact portion with the group of metal needles (collapse starting point) to lead to microbubble emission boiling.

As a result, it is considered that a momentary pressure generated upon the collapse of the bubble is smaller than upon collapse of bubble mass in no contact with the group of needles because the coalesced bubble is divided and collapsed into small bubble mass by the group of needles.

Accordingly, from such consideration, it is considered that the present invention is not limited to the group of rigid needles so far as it is "a convex member" capable of entering the coalesced bubble to form a liquid film and "having good wettability with a liquid (subcooled liquid herein)". Thus, a needle in the group of rigid needles is one form of the convex member.

Thus, a boil cooling method according to the present invention is a boil cooling method, comprising using a surface of an object to be cooled or a surface of a heat-transfer member coming into close contact with the surface of the object to be cooled as a surface to be cooled, providing the surface to be cooled within a tubular flow channel, causing a subcooled cooling liquid to flow through the tubular flow channel, growing bubbles generated by boiling of the cooling liquid on the surface to be cooled, which is heated, up to a critical heat flux, and condensing and collapsing a coalesced bubble formed in a contacted state on the surface to be cooled by the cooling liquid to make high heat flux heat removal, wherein at least part of a group of fine-diameter rigid needles provided in and fixed to the tubular flow channel are brought to a state entered into the coalesced bubble, thereby reducing a pressure generated upon the collapse of the coalesced bubble.

Here, "at least part of the group of rigid needle" means plural needles to the last, and not only one needle among the group of rigid needles (the same shall apply hereinafter).

Another boil cooling method according to the present invention is a boil cooling method, comprising using a surface of an object to be cooled or a surface of a heat-transfer member coming into close contact with the surface of the object to be cooled as a surface to be cooled, providing the surface to be cooled within a tubular flow channel, causing a subcooled cooling liquid to flow through the tubular flow channel, growing bubbles generated by boiling of the cooling liquid on the surface to be cooled, which is heated, up to a critical heat flux, and condensing and collapsing a coalesced bubble formed in a contacted state on the surface to be cooled by the cooling liquid to make high heat flux heat removal, wherein at least part of plural convex members provided in and fixed to the tubular flow channel are brought to a state entered into the coalesced bubble, thereby reducing a pressure generated upon the collapse of the coalesced bubble.

Here, "at least part of the plural convex members" means plural convex members among the plural convex members (all) to the last, and not only one convex member among the plural convex members (the same shall apply hereinafter).

A boil cooling apparatus according to the present invention is a boil cooling apparatus, comprising a tubular flow channel, through which a subcooled cooling liquid is caused to flow, and which is provided with a surface to be cooled, wherein a surface of an object to be cooled or a surface of a heat-transfer member coming into close contact with the surface of the object to be cooled is used as the surface to be cooled, bubbles generated by boiling of the subcooled cooling liquid on the surface to be cooled, which is heated, are grown up to a critical heat flux, and a coalesced bubble formed in a contacted state on the surface to be cooled is condensed and collapsed by the cooling liquid to make high heat flux heat removal, and wherein the tubular flow channel is a flow channel structure having a group of fine-diameter rigid needles provided in and fixed to the tubular flow channel, at least part of which are entered into the coalesced bubble.

Another boil cooling apparatus according to the present invention is a boil cooling apparatus, comprising a tubular flow channel, through which a subcooled cooling liquid is caused to flow, and which is provided with a surface to be cooled, wherein a surface of an object to be cooled or a surface of a heat-transfer member coming into close contact with the surface of the object to be cooled is used as the surface to be cooled, bubbles generated by boiling of the subcooled cooling liquid on the surface to be cooled, which is heated, are grown up to a critical heat flux, and a coalesced bubble formed in a contacted state on the surface to be cooled is condensed and collapsed by the cooling liquid to make high heat flux heat removal, and wherein the tubular flow channel is a flow channel structure having plural convex members provided in and fixed to the tubular flow channel, at least part of which are entered into the coalesced bubble.

In the boil cooling methods and boil cooling apparatus according to the present invention, it may be preferable to use a flow channel structure that the surface to be cooled and a tubular inner wall (hereinafter also referred to as "tubular wall") of the tubular flow channel opposing to this surface are parallel to each other, and the group of rigid needles is fixed to an inner wall portion opposing to the surface to be cooled and provided protrudently toward the surface to be cooled.

In the boil cooling methods and boil cooling apparatus according to the present invention, it may be preferable to use a flow channel structure that the group of rigid needles is provided in at least a row in a flow direction of the tubular flow channel.

In the boil cooling methods and boil cooling apparatus according to the present invention, it may be preferable to use a flow channel structure that the length of the surface to be cooled in a flow direction of the cooling liquid is 1 to 5 cm.

In the boil cooling methods according to the present invention, it may be preferable that the mean flow rate of the cooling liquid flowing within the tubular flow channel is 0.2 m/sec in terms of a lower limit thereof and 1.0 m/sec in terms of an upper limit thereof.

In the boil cooling methods according to the present invention, a subcooling degree at 1 atm may be preferably 20 K or higher, more preferably 30 to 40 K.

In the boil cooling methods according to the present invention, the cooling liquid may preferable be water, alcohol, a mixture of water and alcohol, or a fluorine-containing inert liquid.

In the boil cooling methods according to the present invention, the cooling liquid may preferably be an antifreezing fluid.

In the boil cooling methods according to the present invention, it may be preferable that the cooling liquid is caused to flow through the tubular flow channel in such a manner that the quantity of air within the flow channel is controlled to 0 to 20%.

In the boil cooling methods and boil cooling apparatus according to the present invention, a structure that a tubular secondary flow channel is formed separating from the tubular flow channel, through which the cooling liquid is caused to flow, by a partition wall, and a plurality of fine tubular supply parts for supplying the cooling liquid into the tubular flow channel through the partition wall from the secondary flow channel is provided may be used as the flow channel structure to supply the cooling liquid to the tubular flow channel and the secondary flow channel in the flow channel structure, thereby causing the cooling liquid to flow through both flow channels to conduct cooling together with the cooling liquid in the tubular flow channel that is a main flow channel while supplying the cooling liquid to the tubular flow channel from the secondary flow channel side.

The boil cooling apparatus according to the present invention may be equipped with a cooling liquid-supplying and flowing means for supplying the cooling liquid to the tubular flow channel to cause it to flow.

In the boil cooling apparatus according to the present invention, the cooling surface may preferably form at least a part of the inner wall of the tubular flow channel.

In the boil cooling apparatus according to the present invention, the cooling liquid-supplying and flowing means may preferably have a cooling liquid container for storing the cooling liquid.

In the boil cooling apparatus according to the present invention, the cooling liquid may preferably be stored in the cooling liquid container.

In the boil cooling apparatus according to the present invention, it may be preferable that the cooling liquid-supplying and flowing means has a convection type heat radiating means, and the heat radiating means cools the cooling liquid flowed through the flow channel structure and contributed to the cooling of the surface to be cooled.

In the boil cooling apparatus according to the present invention, the convection type heat radiating means may preferably be an air-cooled radiator.

In the boil cooling apparatus according to the present invention, it may be preferable that the group of rigid needles in the flow channel structure is arranged regularly and in a lattice form.

In the boil cooling apparatus according to the present invention, it may be preferable to use a flow channel structure that the surface to be cooled and the tubular wall opposing to this surface are parallel to each other, and the group of rigid needles is formed protrudently from the tubular wall opposing to the surface to be cooled in such a manner that the tip ends of the group approach to the surface to be cooled with an interval of 0.5 mm or less.

In the boil cooling apparatus according to the present invention, it may be preferable to use a flow channel structure that the sectional form of the tubular flow channel is a substantially rectangular form.

In the boil cooling apparatus according to the present invention, it may be preferable to use a flow channel structure that the sectional form of the tubular flow channel is a circular, elliptical, semicircular or semi-elliptical form.

In the boil cooling apparatus according to the present invention, it may be preferable to use a flow channel structure that a material forming at least a surface of the object to be cooled or the heat-transfer member coming into close contact with the object to be cooled is ultra-hydrophilic.

In the boil cooling apparatus according to the present invention, it may be preferable to use a flow channel structure that a tubular secondary flow channel is formed separating from the tubular flow channel, through which the cooling liquid is caused to flow, by a partition wall, and a plurality of supply parts for supplying the cooling liquid into the tubular flow channel through the partition wall from the secondary flow channel is provided.

The boil cooling apparatus according to the present invention may preferably have a plurality of flow channel structures closely adjoining and paralleling one another.

As described above, the boil cooling method according to the present invention comprises using a surface of an object to be cooled or a surface of a heat-transfer member coming into close contact with the surface of the object to be cooled as a surface to be cooled, providing the surface to be cooled within a tubular flow channel, causing a subcooled cooling liquid to flow through the tubular flow channel, growing bubbles generated by boiling of the cooling liquid on the surface to be cooled, which is heated, up to a critical heat flux, and condensing and collapsing a coalesced bubble formed in a contacted state on the surface to be cooled by the cooling liquid to make high heat flux heat removal, wherein at least part of a group of fine-diameter rigid needles provided in and fixed to the tubular flow channel are brought to a state entered into the coalesced bubble, thereby reducing a pressure generated upon the collapse of the coalesced bubble.

The flow channel structure in the present invention means a structure making up a part of the boil cooling apparatus and having a group of fine-diameter rigid needles provided in the tubular flow channel, through which the subcooled cooling liquid is caused to flow. This "flow channel structure" is essential for the present invention, and the above objects of the present invention can be achieved by the boil cooling methods and boil cooling apparatus comprising "the flow channel structure" as a composing element.

The "tubular flow channel" is a flow channel through which a subcooled cooling liquid is caused to flow and includes 2 types.

The first type is a single structure composed of a tubular body, on the inner wall portion of which a surface to be cooled and a group of rigid needles are provided.

On the other hand, the second type is a double structure composed of a tubular body 50 and a columnar body 51 fixed and arranged along a center axis in the interior thereof, and a surface to be cooled and a group of rigid needles are provided on one of an inner wall portion 50A of the tubular body 50 and a surface 51A of the columnar body, and the other, respectively.

Accordingly, "the inner wall portion of the tubular flow channel" in the present invention means not only the inner wall portion of the tubular body, but also the surface portion of the columnar body.

When boil cooling is conducted by laying a cooling pipe in a heat spreader such as power IC having a high heat-generating density, the second type is used. Since the first type tubular flow channel is used in an ordinary cooling apparatus, however, description will hereinafter be given laying stress on the first type tubular flow channel.

"The object to be cooled" is an object of cooling.

"The heat-transfer member coming into close contact with the surface of the object to be cooled" is a member which is thermally conductive and has a function of spreading "the flow of heat from a heat-generating body", such as "a metal plate brought into close contact with a heat-generating body of an object to be cooled" such as a heat spreader.

"The surface to be cooled" is a surface of the object to be cooled itself, or a surface of the heat-transfer member and is also referred to as a heat-transfer surface. The surface to be cooled may be a flat surface. However, when the surface to be cooled is made a concavo-convex surface or roughened surface such as a ring, spiral or fine groove, the area of the surface to be cooled is increased, which is preferred for obtaining a high heat flux.

In the first type "tubular flow channel", "the object to be cooled makes up a part of the structure of the flow channel structure" when the surface of the object to be cooled is used as the surface to be cooled, while "the heat-transfer member makes up a part of the structure of the flow channel structure" when the surface of the heat-transfer member is used as the surface to be cooled.

"Subcooling" means that the temperature of the cooling liquid is made "a temperature lower than its saturation temperature at which the cooling liquid is boiled at a contact area with the surface to be cooled", and a temperature difference between the saturation temperature (temperature at which boiling occurs in the tubular flow channel) of the cooling liquid and the temperature of the subcooled cooling liquid is called "the subcooling degree" and expressed by "K", and the subcooled cooling liquid is called "a subcooled liquid".

No particular limitation is imposed on "the subcooling degree" in the present invention. However, "the subcooling degree at an end on the upstream side of the surface to be cooled" in the tubular flow channel is adequately 20 K or higher, more preferably within a range of from 30 K to 60 K, still more preferably within a range of from 40 to 50 K taking into consideration stable cooling of a surface to be cooled by microbubble emission boiling and heat radiation of the cooling liquid by a radiator or the like after cooling.

This "range of the subcooling degree" may be applied to not only the case where water is used as the cooling liquid, but also the case where such a mixture of water and alcohol or the like as described below is used.

"The group of rigid needles" used in the present invention means a group composed of a plurality of rigid needles fixed to and provided on the inner wall portion of the tubular flow channel and having a function of reducing an air pressure generated upon collapse as a means for dividing the collapse of the bubble.

In the present invention, as described above, it is also considered that "a convex member" capable of entering the coalesced bubble to form a liquid film and "having good wettability with a liquid (subcooled liquid herein)" may be used. As the convex member, may be used not only rigid needles, but also, for example, a thin plate (collapse-accelerating plate) having a thickness of about 0.1 to 0.5 mm and a length of about 5 to 10 mm. As a material thereof, may be used the same material as the rigid needle, which will be described subsequently.

A group of thin plates can be arranged in the flow channel so as to protrude toward the surface to be cooled like the group of rigid needles. In this case, it is necessary to select the number of thin plates and an arranging method in view of a flow resistance.

Description will hereinafter be given laying stress on the tubular flow channel using the group of rigid needles.
The group of rigid needles may be fixed to the inner wall portion of the tubular flow channel opposing to the surface to be cooled and provided protrudently toward the surface to be cooled. However, the group of rigid needles may also be fixed to the surface to be cooled and provided protrudently toward the opposing inner wall portion. In the latter case, a root portion of the rigid needle fixing to the surface to be cooled becomes a bubbling point to easily generate bubbles. Therefore the former case is far preferred.

However, even in the case of the latter, the generation of bubbles can be controlled by smoothing the form of the root portion so as to draw an arc, and the group of rigid needles can be expected to develop a fin function so as to enhance the cooling effect.

"The rigid needle" used in the present invention is not limited to "a needle-like member" alone and includes various kinds of rod-like members. As the rod-like member, may be used that having a circular or tetragonal form in section and having rigidity required to fulfill a function as the bubble collapse-dividing means. In the present invention, these members are generically referred to as "rigid needle".

In the first type "tubular flow channel", when the group of rigid needles is fixed to the inner wall portion of the tubular flow channel opposing to the surface to be cooled and provided protrudently toward the surface to be cooled, the individual rigid needles form "a proper angle with the tubular wall".

This "proper angle" may be any angle so far as the group of rigid needles can fulfill the function. For example, when the surface to be cooled is provided over the tubular flow channel, and the sectional form of the tubular flow channel is rectangular, the proper angle is an angle perpendicular or substantially perpendicular to the tubular wall.

"The fine-diameter rigid needle" in the present invention means a rigid needle having a thickness "not to become a great resistance to the flow of the cooling liquid" in a state protruded as the group of rigid needles within the flow channel, and the thickness can be optimized according to the sectional area of the tubular flow channel, the number of rigid needles making up the group of rigid needles, the flow rate of the cooling liquid, etc. For example, the diameter of the rigid needle is about 0.1 mm to 1 mm.

"The rigidity required of the group of rigid needles to fulfill the function" is rigidity for preventing great distortion or deformation by the flow of the cooling liquid. Accordingly, even in this case, the rigidity can be optimized according to the flow rate (flow speed) of the cooling liquid, and the like.

No particular limitation is imposed on a material of the respective rigid needles. However, "a material high in thermal conductivity", which has "necessary rigidity", also has heat resistance and rust preventiveness and is "good in wettability with the cooling liquid" is preferred. For example, a metal such as stainless steel or aluminum, or a synthetic resin having a high softening point, such as Teflon (trademark), is used.

The arrangement of the group of rigid needles in a high density, i.e., the arrangement of individual rigid needles, may be regular or random.

The regular arrangement is an arrangement in an order way, such as matrix arrangement or zigzag arrangement, while the random arrangement is an arrangement having no certain regularity, but an arrangement that the number of rigid needles per unit area does not greatly vary.

By the observation of the present inventors, the group of rigid needles regularly arranged is particularly effective for reducing the air pressure generated by the collapse of the coalesced bubble. This is considered to be attributable to the fact that 4 rigid needles adjoining one another at equal intervals forms a lattice, and 4 recesses or concave portions formed at 4 contact portions between these needles and the coalesced bubble have equivalent collapsing force.

The arrangement density of the group of rigid needles in either the case of "the regular arrangement" or the case of "the random arrangement" may be constant along the flow direction of the tubular flow channel. However, the arrangement density may be made "higher on the downstream side of the cooling liquid flowed".

No limitation is imposed on the number of rows in the regular arrangement of the group of rigid needles in the flow direction, and the number depends on the width of the tubular flow channel. However, 2 or more rows are preferred for achieving such effect as described above by forming the lattice by the 4 rigid needles adjoining one another at equal intervals though one row may be allowed when the width of the tubular flow channel is narrow, with 4 to 8 row being more preferred.

It is also effective to make the arrangement density of the rigid needles in a width direction (direction perpendicular to the flow direction) to the flow direction of the group of rigid needles high. If the arrangement density is too high, however, such a group of rigid needles resists the flow of the cooling liquid. Accordingly, the interval between the rigid needles is preferably 2 to 5 mm, particularly preferably 2 to 3 mm.

With respect to the arrangement of the rigid needles, it is far effective to make the density in the width direction higher rather than the fact that the density is made higher on the downstream side of the tubular flow channel than on the upstream side.

When plural rigid needles making up the group of rigid needles are provided from the tubular wall portion opposing to the surface to be cooled toward the surface to be cooled, they are preferably arranged regularly in a lattice form on the tubular wall portion, and the rigid needles are preferably arranged in such a manner that the tip end of each rigid needle approaches to the surface to be cooled with a slight interval without being brought into contact with the surface to be cooled.

It is considered that the group of rigid needles are provided regularly in 2 or more rows as described above, whereby the coalesced bubble grown on the surface to be cooled comes into contact with the rigid needles in such a manner that the rigid needles arranged in the lattice form strike through the bubble, and the recesses or concave portions formed by a surface tension becomes a factor of dividing the coalesced bubble into fine cells. Accordingly, it is also inferred that bubbles present in respective cells individually collapse when the bubbles collapse by the microbubble emission boiling.

In this case, a momentary pressure generated upon the collapse is related to the size of the bubble, and it is thus considered that when the density of the rigid needles is increased to make the size of the cell small, the momentary pressure generated is lowered. Since the flow resistance of the subcooled liquid is increased, however, it is necessary to suitably select the thickness and arrangement density of the rigid needles according to conditions such as the length and width of the surface to be cooled.

Methods for providing the rigid needles on the tubular wall of the tubular flow channel so as to protrude within the flow channel include a method, in which holes are made in the tubular wall, and one end portion of each rigid needle is embedded therein and fixed with an adhesive or the like, a method, in which one end portion of each rigid needle is fixed to the surface of the tubular wall by brazing or the like without making holes, a method, in which when the tubular wall is made of a heat-resistant resin plate, one end portion of each rigid needle is heated, pressed into the resin plate and then cooled to fix it, and a method, in which the tubular flow channel and rigid needles are integrally formed by molding or the like. In any event, high durability is required under a high-heat environment in such a manner that the fixed rigid needles are not taken off.

When the rigid needles made of, for example, "a material high in thermal conductivity" are protruded within the flow channel by embedding in or bonding to the surface to be cooled making up the tubular wall of the tubular flow channel, the group of fine-diameter rigid needles is integral with the surface to be cooled, whereby the surface area of the surface to be cooled is increased to increase a contact area with the cooling liquid and effectively improve the heat-transferring efficiency to the cooling liquid.

In order to make the effect on condensation collapse greater, it is considered that the temperature of the group of rigid needles is kept lower than the temperature of the cooling liquid. In the case of the flow channel structure that one end portions of the respective rigid needles making up the group of rigid needles are protruded from the tubular wall opposing to the surface to be cooled toward the surface to be cooled, thus, the other end portions are struck through the tubular wall portion and fixed to the tubular wall portion so as to protrude from the outer wall surface of the tubular flow channel, whereby heat is radiated from the other end portions of the rigid needles on the outer wall surface by natural convection to the air. In addition, the group of rigid needles may be cooled by providing such cooling means that air is blown against the other end portions of the rigid needles on the outer wall surface by an air blower, or a duct is provided to send air, thereby radiating heat by forced convection.

The structure that the rigid needles are embedded in the surface to be cooled is effective for increasing a cooling surface. However, this structure is not preferred because the contact portions between the surface to be cooled and the rigid needles become bubbling points, and so the contact portions covered with bubbles may become high temperature in some cases, which has a possibility of partial "burning-out".

On the other hand, in the case where the rigid needles are made of "a material high in thermal conductivity", the rigid needles are protruded within the flow channel by embedding in or bonding to the surface to be cooled making up the tubular wall of the tubular flow channel, the group of fine-diameter rigid needles is integral with the surface to be cooled, whereby the surface area of the surface to be cooled is increased to increase a contact area with the cooling liquid and effectively improve the heat-transferring efficiency to the cooling liquid, and thus this structure is preferred.

In the flow channel structure of the present invention, the sectional form of the tubular flow channel is preferably "rectangle", and the flow channel structure may be so constructed that "the surface to be cooled and the tubular inner wall opposing to this surface" are parallel to each other, and the group of rigid needles is protruded from the surface to be cooled and/or the tubular wall opposing to the surface to be cooled in such a manner that the tip ends of the group of rigid needles "approach to or come into contact with the tubular wall opposing to the surface to be cooled, or the surface to be cooled", which is an opposite surface.

When the tip ends of the group of rigid needles are caused to "approach to or come into contact with the tubular wall opposing to the surface to be cooled, or the surface to be cooled", the rigid needles themselves have a cooling effect as heat-radiating fins. In order to effectively fulfill such a function as a heat-radiating fin, a thermally conductive material is preferably used as a material of the rigid needles. When the tip ends of the group of rigid needles are caused to "approach to the tubular wall opposing to the surface to be cooled, or the surface to be cooled", an interval with the tubular wall caused to approach is preferably at most 0.1 mm or less.

However, it is considered that when the tip ends of the rigid needles are brought into contact with the surface to be cooled, the contact portions become bubbling points, and consequently the contact portions covered with bubbles become high temperature, leading to "burning-out". Therefore, if the interval is 0.1 mm or less, it is preferable that the group of rigid needles is caused to approach without being brought into contact.

The fact that "the surface to be cooled and the tubular wall opposing to this surface are parallel to each other" includes not only the case where these surfaces are flat surfaces and oppose in parallel to each other, but also the case where these surfaces are cylindrical surfaces or the like and oppose in parallel to each other. In other words, the surface to be cooled and the tubular wall opposing to this surface may be flat surfaces or curved surfaces.

In the flow channel structure of the present invention, the sectional form of the tubular flow channel may be "circular or elliptical" or "semicircular or semi-elliptical" in addition to "rectangular". For example, when "a hole in a circular or elliptical sectional form" is made in the object to be cooled or the heat-transfer member, "a surface in a cylindrical surface or elliptic-cylindrical surface form" is formed in the interior of the object to be cooled or the heat-transfer member. Therefore, cooling by microbubble emission boiling can be conducted by using the surface in this cylindrical surface or elliptic-cylindrical surface form as a surface to be cooled, and causing the cooling liquid to flow through a tubular flow channel having this surface as a tubular wall.

In this case, all the tubular wall of the tubular flow channel becomes "a surface in the cylindrical surface or elliptic-cylindrical surface form" of the object to be cooled or the heat-transfer member".

The flow channel structure according to the present invention may be widely applied to various products that generate heat during operation and comprise a cooling means for this heat as a composing element as described below, and the length of a surface to be cooled, along which a cooling liquid is caused to flow, varies according to the products.

When the flow channel structure according to the present invention is used as a single member, "the length of the surface to be cooled, along which the cooling liquid is caused to flow," is adequately 1 cm to 5 cm for sufficiently developing the expected effect of microbubble emission boiling, and the length is preferably at most about 5 cm. When the length of the surface to be cooled is longer, a plurality of the flow channel structures according to the present invention is preferably used in serial combination.

When an electronic package long in the surface to be cooled is required, the length of the surface to be cooled is divided into, for example, plural 5-cm packages, and the cooling apparatus according to the present invention is arranged in a sandwich way, whereby high heat flux cooling can be compactly conducted.

In other words, the flow channel structure according to the present invention may be constructed into "a structure having plural tubular flow channels in close series or parallel to each other. When the plural tubular flow channels are combined in parallel, the flow directions of the cooling liquid in the plural tubular flow channels may be the same direction. However, among the plural tubular flow channels, at least one tubular flow channel, through which the cooling liquid is caused to flow in a direction reverse to other tubular flow channels, may be provided. The plural tubular flow channels are provided in combination in such a manner, whereby a cooling region in a parallel arrangement direction of a flow channel can be increased.

The flow channel structure according to the present invention may be so constructed that "a tubular secondary flow channel is formed separating from the tubular flow channel, through which the cooling liquid is caused to flow, by a partition wall, and a plurality of supply parts for supplying the cooling liquid into the tubular flow channel through the partition wall from the secondary flow channel is provided".

The secondary flow channel may be formed at a position separating from the surface to be cooled through the tubular flow channel, or may be formed on a side along the flow direction of the tubular flow channel.

"The supply parts" may be formed as "through-holes" in the partition wall to the tubular flow channel, or the partition wall itself may be porously formed. Further, the supply parts may be provided so as to protrude like nozzles on the side of tubular flow channel from the partition wall, whereby the tip ends thereof are approached to the surface to be cooled.

In this case, "the flow directions of the cooling liquid" in the tubular flow channel and secondary flow channel of the flow channel structure may be the same directions or reverse directions to each other. Quite naturally, the cooling liquid caused to flow through the secondary flow channel is "the subcooled liquid".

The flow channel structure according to the present invention is favorably constructed by a material good in thermal conductivity. For example, gold, silver and aluminum have a high thermal conductivity. In particular, silver is suitable for use as a material of the flow channel structure from the viewpoint of a high thermal conductivity. However, aluminum is preferred from the viewpoint of cost.

Further, it is preferable to use a material having stable rust preventiveness and high corrosion resistance and heat resistance in addition to the material good in thermal conductivity. For example, aluminum, stainless steel, ceramic, acrylic resin or the like subjected to a rust preventive treatment may be suitably used.

The boil cooling apparatus according to the present invention is "an apparatus for conducting cooling by microbubble emission boiling" and has at least a flow channel structure and a cooling liquid-supplying and flowing means.

"The flow channel structure" has a tubular flow channel, through which a subcooled cooling liquid is caused to flow, and which is formed by using a surface of an object to be cooled or a surface of a heat-transfer member coming into close contact with the surface of the object to be cooled as a surface to be cooled, and using the surface to be cooled as a tubular wall, and has a structure that a group of fine-diameter rigid needles is protruded from the tubular wall of the tubular flow channel within the flow channel. Specifically, the above-described flow channel structure is used.

"The cooling liquid-supplying and flowing means" is a means for supplying a cooling liquid caused to flow through the tubular flow channel or the tubular flow channel and secondary flow channel of the flow channel structure to the flow channel structure to cause it to flow.

"The cooling liquid-supplying and flowing means" can cause the cooling liquid to flow between a cooling liquid container for storing the cooling liquid and the flow channel structure. In this case, "a state that the cooling liquid has been stored in the cooling liquid container" is included.

"The cooling liquid-supplying and flowing means" may have a convection type heat radiating means as a composing element.

"The convection type heat radiating means" effectively radiates heat transferred to the cooling liquid flowed through the flow channel structure from the surface to be cooled to permit boil cooling with good efficiency. This heat radiating means may be either an air convection system or a system of convecting a liquid such as water. However, an air-cooled radiator is preferred.

No particular limitation is imposed on the cooling liquid in the boil cooling apparatus according to the present invention, and any liquid may be used so far as it "has a proper saturation temperature to a temperature of the surface to be cooled". However, water, alcohol, a mixture of water and alcohol, or a fluorine-containing inert liquid is particularly preferred from the viewpoints of easy availability, low cost, easy handling, safety, and chemical and physical stability. "Water" is particularly preferred as the cooling liquid from the viewpoint of environmental protection. As the fluorine-containing inert liquid, "FLUORINERT (trademark, product of Sumitomo 3M Limited) is commercially available.

As "the mixture of water and alcohol", is preferred a cooling liquid containing, as the alcohol, ethyl alcohol and propyl alcohol at proportions of 5 to 15%, respectively, based on water.

When "the mixture of water and alcohol" is used as described above, the subcooling degree is preferably 20 K or higher like the case of water. It has been confirmed that if the subcooling degree is less than 20 K, microbubble emission boiling is hard to occur.

As compared with the use of water alone, the use of "the mixture of water and alcohol" as the cooling liquid permits making microbubbles after collapse clearly small, further reducing vibration by pressure upon collapse of the coalesced bubble by about 50% and obtaining a heat flux higher by about 30%.

The reason why the vibration by pressure can be reduced is considered to be attributable to the fact that when water is mixed with alcohol, the surface tension of the mixture becomes smaller than that of water alone, and so the bubble is easier to be collapsed. The reason why the high heat flux can be obtained is considered to be attributable to the fact that "the alcohol low in boiling point evaporates first" upon boiling, whereby "a difference in alcohol concentration caused between the vicinity of a place, to which a bubble has adhered," of the heat-transfer surface and the mixture causes a difference in the surface tension of the bubble, so that the mixture is drawn by "a high surface tension at a low-temperature portion in an upper part of the bubble" of a vapor-liquid interface to generate a flow (called Marangoni flow) toward the upper part of the bubble, thereby supplying the cooling liquid low in temperature toward "the surface, to which the bubble has adhered, of the heat-transfer surface" to accelerate vapor-liquid exchange.

When the boil cooling apparatus according to the present invention is used in a cold district or a low-temperature atmosphere, there is a possibility that the function as a cooling apparatus may not be fulfilled by freezing of the cooling liquid. As a countermeasure thereof, the cooling liquid may be changed to an antifreezing fluid as "a means for preventing the freezing".

The antifreezing fluid may be suitable selected for use according to products in which the boil cooling apparatus of the present invention is installed, and a commercially available product may also be used. For example, an antifreezing fluid comprising ethylene glycol as a main component may be used. In place of ethylene glycol, however, an alcohol such as methyl alcohol or ethyl alcohol and water may be used as an antifreezing fluid with their concentrations adjusted.

For example, the freezing points (°C) of a mixture (Mixture 1) of water and ethylene glycol, a mixture (Mixture 2) of water and methyl alcohol and a mixture (Mixture 3) of water and ethyl alcohol are varied according to the concentration (%) of a component mixed with water, such as ethylene glycol, and are as shown in the following Table 1.

**[Table 1]**

| Concentration (%) | 1 0 | 2 0 | 3 0 | 4 0 |
|---|---|---|---|---|
| Mixture 1 | - 3 °C | - 8 °C | -15.5 °C | - 25 °C |
| Mixture 2 | - 5 °C | - 12 °C | - 21 °C | - 33 °C |
| Mixture 3 | -2. 5 °C | - 7 °C | - 13 °C | - 22 °C |

As a material forming at least a surface of "the object to be cooled or the heat-transfer member coming into close contact with the object to be cooled" making up the surface to be cooled in the flow channel structure of the present invention, may be used not only a member which is thermally conductive and has a function of spreading "the flow of heat from a heat-generating body", such as a metal plate described above, but also "an ultra-hydrophilic material".

The heat-transfer surface is formed by a film (hydrophilic film or ultra-hydrophilic film) formed from a hydrophilic material, whereby the wettability of the heat-transfer surface with the cooling liquid can be improved to accelerate separation of a bubble and increase a critical heat flux in cooperation with the microbubble-emitting effect by the rigid needles.

As the hydrophilic material, the materials mentioned in, for example, Japanese Patent Nos. 3340149, 3147251 and 259931, and Japanese Patent Application Laid-Open Nos. 2005-55066, 2002-062069, 2001-1336890, 2000-144052 and 2000-103645 may be suitably applied according to products in which the flow channel structure of the present invention is used.

According to an experiment by the present inventors, it was confirmed that "a ceramic hydrophilic film formed at 500 to 600°C" increases a critical heat flux by 10 to 20%, and an effect of accelerating separation of the bubble is high under a microgravity environment.

The present invention will be described with reference to the drawings.

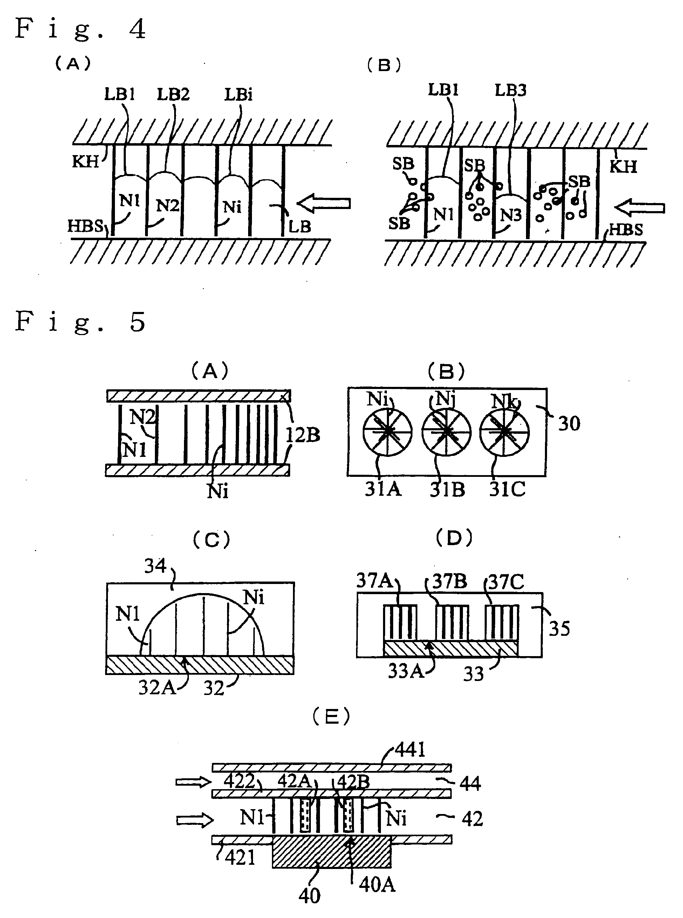

FIG. 4(A) and FIG. 4(B) are typical cross-sectional views illustrating a flow channel structure according to the present invention. In the flow channel structure, rigid needles N1, N2, · · · Ni are protruded from a tubular wall KH toward a surface HBS to be cooled to fix a group of rigid needles in a row on the tubular wall KH, and a group of the same rigid needles (not illustrated) is fixed as a second row in parallel to the illustrated group of rigid needles in a width direction (direction perpendicular to the paper) of the tubular wall KH.

Both FIG. 4(A) and FIG. 4(B) indicate a state that a subcooled cooling liquid (indicated by an arrow in the drawing) flows from the right side to the left side along the tubular wall KH of the flow channel structure, and illustrate a state that a time elapsed from the time the cooling liquid has started to flow is longer in FIG. 4(A) than FIG. 4(B), and microbubbles SB generated on the surface HBS gradually coalesce with one another with the flow and grow as the contact time with the surface HBS to be cooled becomes long.

FIG. 4(B) illustrates a state that the microbubbles grow into a coalesced bubble LB, and FIG. 4(A) illustrates a state that the coalesced bubble LB has been formed within a lattice formed by adjoining 4 rigid needles of the groups of rigid needles in the 2 rows adhering to the surface HBS to be cooled so as to cover a part of the surface to be cooled.

The microbubbles SB gradually grow into the coalesced bubble, and the coalesced bubble becomes "a state the rigid needles have been struck in" the coalesced bubble LB or a state that the rigid needles have been entered into the coalesced bubble BL with the growth of the microbubbles, and comes into contact with the adjoining 4 rigid needles of the groups of rigid needles in the 2 rows. At the 4 contact portions, such a recess or concave part as cave in on a coalesced bubble side and rise on a cooling liquid side is formed by a surface tension, and the surface of the coalesced bubble LB forms such a state divided into a plurality of convexly curved surfaces LB1, LB2, ··· LBi according to the distribution of the rigid needles.

It is considered that as described above, the lattices formed by the group of rigid needles form the state of "the recess or concave part" or "convexly curved surface" without collapsing the coalesced bubble at a time to bring about the effect of preventing generation of the high momentary pressure, which forms the cause of vibration and noise.

The state that the surface of the coalesced bubble is formed by "the plural convexly curved surfaces" as described above is great in surface energy and unstable compared with "a coalesced bubble LB having a single surface" formed in the case where the group of rigid needles is not used as illustrated in FIG. 1(B)(a), and "the collapse into microbubbles by the subcooled liquid" in this state is considered as collapse at each of the plural convexly curved surfaces LB1, LB2, ··· LBi without causing momentary collapse as the whole coalesced bubble LB.

In other words, it is inferred that collapse occurs at "the most easily collapsed portion" among the convexly curved surfaces LB1, LB2, ··· LBi, and this collapse triggers collapse at other convexly curved surfaces to lead to the whole collapse. FIG. 4(B) illustrates a state that the collapse into microbubbles SB has started at the convexly curved surfaces excluding the convexly curved surfaces LB1 and LB3.

The boil cooling method according to the present invention is a cooling method using the boil cooling apparatus described above.

In the boil cooling method according to the present invention, no particular limitation is imposed on the flow rate of the cooling liquid flowing through the tubular flow channel of the flow channel structure making up the boil cooling apparatus. However, the flow rate is preferably 0.2 m/sec or more, more preferably 0.4 m/sec. If the flow rate is less than 0.2 m/sec, "removal of bubbles on the heat-transfer surface" may not be made in some cases.

The upper limit of the flow rate of the cooling liquid is preferably about 1.0 m/sec, more preferably 0.6 m/sec. If the upper limit exceeds 1.0 m/sec, there is a tendency to increase the flow resistance of a pipeline for flowing of the cooling liquid to increase the driving force for causing the cooling liquid to flow.

In order to cause the cooling liquid to flow through the tubular flow channel, it is preferable to control a pressure on the right upstream side in FIG. 4(A) and FIG. 4(B) to a pressure somewhat higher than 1 atm, for example, 1.02 to 1.15 atm and a pressure on the left outlet side to 1 atm together with the above-described flow rate.

In the boil cooling method according to the present invention, an ultrasonic wave may be applied from an outer surface of the tubular flow channel, which is opposed to an inner wall portion to which the group of rigid needles is fixed, to accelerate the microbubble emission, thereby more stably conducing the microbubble emission boiling, and the boil cooling apparatus may be provided as one equipped with an ultrasonic wave generating device.

Since the temperature of the cooling liquid caused to flow through the tubular flow channel and used in the cooling of the surface to be cooled is raised to lower the subcooling degree, a heat radiating means such as a radiator is used for recovering the subcooling degree to the original subcooling degree. For example, it takes a considerably long time to recover the cooling liquid heated to a high temperature and boiled to the original subcooling degree, 40 K. However, it does not take a very long time to recover it to 20 K.

However, when the subcooling degree of the cooling liquid is 20 K, the degree of microbubble emission boiling comes to be lowered. In this case, it has been proved that when cooling is conducted by applying an ultrasonic wave of about 20 kHz and using a cooling liquid having a subcooling degree of 20 K, a heat removal heat flux higher by twice or more compared with the case where no ultrasonic wave is applied is obtained.

According to the boil cooling method of the present invention, a heat flux of 300 W/m² or more, particularly about 500 W/m² can be easily obtained, and vibration and noise can be effectively reduced by 60% or more.

When a flow channel structure having a secondary flow channel is used as the flow channel structure used in the boil cooling apparatus in the boil cooling method of the present invention, the cooling liquid can be supplied to the tubular flow channel and secondary flow channel of the flow channel structure by the cooling liquid-supplying and flowing means to cause it to flow, thereby conducting cooling while supplying the cooling liquid to the tubular flow channel from the secondary flow channel side.

In this case, the supply of the cooling liquid to the tubular flow channel from the secondary flow channel may be "forcedly" conducted by making the pressure within the secondary flow channel higher than the pressure within the tubular flow channel. Alternatively, "a difference in dynamic pressure" between the cooling liquid flowing through the tubular flow channel and the cooling liquid flowing through the secondary flow channel or capillary phenomenon may be utilized to infuse the cooling liquid in the secondary flow channel into the tubular flow channel.

The boil cooling apparatus according to the present invention may be applied to "products that generate heat during operation and comprise a cooling means for this heat as a composing element. As examples thereof, may be mentioned electronic devices and fuel cells, which have a heat-generating body, the surface of which becomes at least a part of the tubular wall of the flow channel structure making up the boil cooling apparatus.

Examples of the products include power conversion-controlling units of hybrid automobiles, electric automobiles, fuel cell-operated automobiles and fuel cell-operated power generation facilities, and power conversion-controlling units of power systems for computers or supercomputers, or railway electric cars or airplanes, in which a high heat-generating density electronic equipment comprising an electronic device and a heat-transfer member as main composing elements is installed, and wherein the tubular flow channel of the flow channel structure making up the boil cooling apparatus is formed by using the heat-transfer member as the tubular wall thereof.

IGBT using a Si substrate, which is widely used at present, tends to increase a heat-generating density as the output thereof is made high, and the cooling apparatus and cooling method of the present invention are extremely effective for cooling of such an electronic device.

The flow channel structure according to the present invention will now be described by modifications of the above-described first type tubular body that the surface to be cooled and the group of rigid needles are provided on the inner wall portion thereof. Five modifications are illustrated in FIG. 5.

An embodiment illustrated in FIG. 5(A) is an example where a subcooled cooling liquid flows from the right to the left in the drawing, and the arrangement density of the group of rigid needles N1, N2, ··· Ni ··· protruding in the flow channel from a tubular wall of a flow channel member 12B forming a part of a tubular flow channel is higher on the downstream side of the cooling liquid. Each rigid needle is preferably fixed in such a manner that the tip end thereof approaches to the opposing tubular wall without being brought into contact with the tubular wall.

As described above, microbubbles generated by nucleate boiling gradually coalesce with one another with the flow of the cooling liquid, and the grown coalesced bubble adheres to the surface to be cooled, so that the coalesced bubble becomes big and easily adheres to the surface to be cooled on the downstream side of the cooling liquid. Accordingly, the density of the group of rigid needles for "collapsing the coalesced bubble into small portions" is made high on the downstream side, whereby the number (number of convexly curved surfaces LBi in FIG. 4(A)) of small portions divided from the coalesced bubble becomes great, and so the effect by the group of rigid needles is more effectively developed.

An embodiment illustrated in FIG. 5(B) is an example where the sectional form of the tubular flow channel is "circular".

More specifically, in this embodiment, holes in a circular sectional form are made in the interior of the object to be cooled to form tubular flow channels 31A, 31B and 31C. The whole surfaces of these tubular flow channels 31A, 31B and 31C are surfaces to be cooled, and the cooling liquid may be caused to flow in a direction perpendicular to the drawing through these tubular flow channels to conduct cooling by microbubble emission boiling.

Rigid needles Ni, Nj and Nk respectively making up groups of rigid needles protrude within the respective tubular flow channels at an angle perpendicular to the tubular wall of each tubular flow channel. However, when the group of rigid needles is fixed to the tubular wall of the tubular flow channel, joint portions thereof are liable to become bubbling points, so that the joint portions are preferably smoothed so as to draw an arc.

The embodiment illustrated in FIG. 5(B) is an example where the plural tubular flow channels 31A, 31B and 31C are arranged closely and in parallel to one another.

An embodiment illustrated in FIG. 5(C) is an example where the sectional form of the tubular flow channel is "semicircular".

A flow channel member 34, in which a semicylindrical tubular wall having an arched sectional form has been formed, is provided on a surface 32A to be cooled of an object 32 to be cooled, and the tubular flow channel is formed integrally with the object 32 to be cooled. The group of rigid needles N1, N2, ··· Ni ·· is provided at an angle perpendicular to the surface 32A to be cooled so as to protrude within the tubular flow channel from the side of the surface 32A to be cooled forming a part of the tubular wall of this tubular flow channel. Each rigid needle is preferably fixed in such a manner that the tip end thereof approaches to the opposing tubular wall without being brought into contact with the tubular wall. The lengths of the rigid needles Ni vary according to the semicircular sectional form of the tubular flow channel.

An embodiment illustrated in FIG. 5(D) is an example where a surface 33A to be cooled of an object 33 to be cooled and a flow channel member 35 are combined, and tubular flow channels 37A, 37B and 37C in a rectangular sectional form are formed closely and in parallel to one another. The group of rigid needles is provided in each of the tubular flow channels 37A, 37B and 37C as illustrated in the drawing. Each rigid needle is preferably fixed in such a manner that the tip end thereof approaches to the opposing tubular wall without being brought into contact with the tubular wall.

An embodiment illustrated in FIG. 5(D) is an example where a tubular secondary flow channel 44 is formed to a flow channel 42, through which a refrigerant (cooling liquid) is caused to flow, through a partition wall, and plural supply parts 42A and 42B for supplying a cooling liquid into the tubular flow channel 42 through the partition wall from the secondary flow channel 44 are provided. The tubular flow channel 42 is formed by flow channel members 421 and 422 using a surface 40A to be cooled of an object 40 to be cooled as a part of a tubular wall. The group of rigid needles N1, ··· Ni ·· protrudes within the tubular flow channel 42 from the side of the flow channel member 422 at an angle perpendicular to the tubular wall of the tubular flow member 422. The tip end of each rigid needle approaches to the surface 40A to be cooled.

The flow channel member 422 also serves as the partition wall separating the tubular flow channel 42 from the secondary flow channel 44, and the secondary flow channel 44 is formed by the flow channel member 422 serving as the partition wall and a secondary flow channel member 441. The sectional form of the tubular flow channel 42 and the secondary flow channel 44 is rectangular. However, the form may be any other sectional form such as a circular or semicircular form. In the embodiment illustrated in FIG. 5(E), a subcooled cooling liquid (indicated by an arrow in the drawing) is caused to flow through the tubular flow channel 42 and secondary flow channel 44 in the same direction (direction toward the right from the left in the drawing). However, the direction is not limited to this direction, and the flow directions of the cooling liquid in the tubular flow channel 42 and secondary flow channel 44 may be reversed to each other.

The supply parts 42A and 42B are provided so as to protrude like nozzles on the side of the tubular flow channel from the partition wall 422, whereby the tip ends thereof are approached to the surface 40A to be cooled.

When such a flow channel structure is used, the temperature of the cooling liquid flowing through the tubular flow channel can be effectively lowered by supplying the subcooled liquid from the secondary flow channel side to promote "the microbubble emission collapse effect" that the subcooled liquid has, in addition to the effect by the group of rigid needles.

As described above, the supply of the cooling liquid to the tubular flow channel 42 from the secondary flow channel 44 may be "forcedly" conducted by making the pressure within the secondary flow channel 44 higher than the pressure within the tubular flow channel 42. Alternatively, "a difference in dynamic pressure" between the cooling liquid flowing through the tubular flow channel 42 and the cooling liquid flowing through the secondary flow channel 44 or capillary phenomenon may be utilized to infuse the cooling liquid in the secondary flow channel 44 into the tubular flow channel 42.

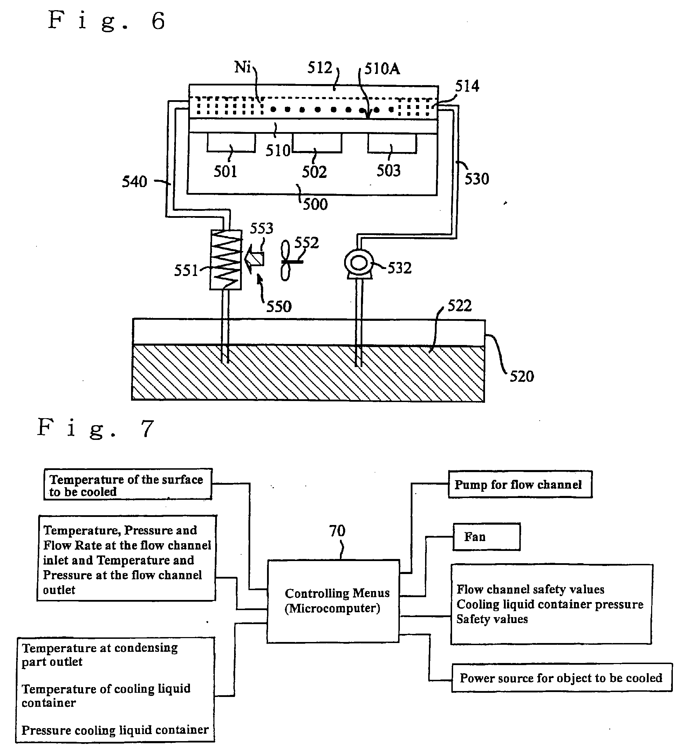

FIG. 6 illustrates a boil cooling apparatus according to an embodiment of the present invention.

In FIG. 6, character 500 indicates an object to be cooled, which has heat-generating parts 501, 502 and 503. A heat spreader 510 is provided as "a heat-transfer member" in contact with the heat-generating parts 501, 502 and 503. In the drawing, an upper surface of the heat spreader 510 is a smooth flat surface 510A to be cooled.

Character 512 indicates a flow channel member which forms "a tubular flow channel" together with the heat spreader 510. More specifically, a part of the tubular wall of the tubular flow channel 514 is the surface 510A to be cooled of the heat spreader 510, and a group of rigid needles by rigid needles Ni protrudes within the tubular flow channel 514. In the tubular flow channel 514, each rigid needle Ni protrudes at an angle perpendicular to the tubular wall from an upper tubular wall in the drawing, and the tip end thereof approaches to the surface 510 to be cooled.

In other words, the heat spreader 510 and the flow channel member 512 having the group of rigid needles are a flow channel structure having the tubular flow channel 514, through which a subcooled cooling liquid is caused to flow, and which is formed by using a surface of the heat-transfer member 510 coming into close contact with a surface of the object 500 to be cooled as the surface 510A to be cooled, and using the surface 510A to be cooled as a tubular wall, and has a structure that a group of fine-diameter rigid needles is protruded from the tubular wall of the tubular flow channel 514 within a flow channel.

In FIG. 6, characters 520 and 522 indicate "a cooling liquid container" and "a cooling liquid", respectively. Character 532 indicates "a pump for flow channel", characters 530 and 540 each indicate "a pipeline for cooling liquid", and character 550 indicates "a condensing means".

The pump 532 for flow channel and the condensing means 550 are controlled by "a controlling means" which will be described subsequently.

The cooling liquid 522 is stored in the cooling liquid container 520. As the cooling liquid, may preferable be used water, alcohol, a mixture of water and alcohol, or a fluorine-containing inert liquid. In particular, "pure water" or "a cooling liquid containing, as the alcohol, ethyl alcohol and propyl alcohol at proportions of 5 to 15%, respectively, based on water", which has been described in the above embodiment, is preferred. It goes without saying that an antifreezing fluid may be used as the cooling liquid.

When cooling is conducted, the cooling liquid 522 in the cooling liquid container 520 is sucked up by the pump 532 for flow channel and supplied to the tubular flow channel 514 of the flow channel structure through the pipeline 530 for cooling liquid. The cooling liquid 522 supplied to the tubular flow channel conducts cooling by microbubble emission boiling while flowing within the tubular flow channel. At that time, pressure fluctuation in the tubular flow channel is effectively lightened by the action of the group of rigid needles protruding within the tubular flow channel to lighten both noise and pressure.

The cooling liquid 522 passed through the tubular flow channel 514 is returned to the cooling liquid container 520 through the pipeline 540 for cooling liquid. In the middle thereof, the cooling liquid is condensed by the condensing means 550.

The condensing means 550 is constructed by a condensing part 551 incorporated into the pipeline 540 for cooling liquid and a fan 552 for blowing cooling air 553 against the condensing part 551. In the condensing part 551, its flow channel is made long, and the cooling liquid 522 is cooled and condensed while flowing through this part, and returned to the cooling liquid container 520.

In other words, the cooling liquid container 520, the pipelines 530 and 540 for cooling liquid, the pump 532 for flow channel, and the condensing means 550 make up "a cooling liquid-supplying and flowing means" for supplying the cooling liquid to the flow channel structure to cause it to flow.

Accordingly, "the cooling liquid-supplying and flowing means" of the boil cooling apparatus according to the embodiment illustrated in FIG. 6 serves to cause the cooling liquid to flow between the flow channel structure 510, 512 and the cooling liquid container 520.

Accordingly, according to the boil cooling apparatus in FIG. 6, the boil cooling method according to the present invention is performed.

Incidentally, it goes without saying that the boil cooling method according to the present invention may be performed by using the flow channel structure having the secondary flow channel as illustrated in FIG. 5(E) as the flow channel structure in the boil cooling apparatus illustrated in FIG. 6 and conducting cooling while "supplying the cooling liquid to cause it through the tubular flow channel and secondary flow channel of the flow channel structure and supplying the cooling liquid into the tubular flow channel from the secondary flow channel side.

FIG. 7 simply illustrates a manner of control by the controlling means 70.

The controlling means 70 is "a microcomputer". Though no description has been made above, various sensors are used in the boil cooling apparatus illustrated in FIG. 6 to detect "the temperature of the surface to be cooled", "the temperature, pressure and flow rate at the flow channel inlet, and the temperature and pressure at the flow channel outlet in the tubular flow channel", and "the temperature at the condensing part outlet, and the temperature and pressure of the cooling liquid container".

Of these detections, the detection of various temperatures is conducted by "a temperature sensor such as a thermocouple", the detection of various pressures is conducted by "a manometer such as a semiconductor pressure sensor", and the detection of various flow rate is conducted by "a flowmeter such as a float area type flowmeter".

The detection results of these various temperatures flow rates and pressures are inputted into the controlling means 70, and the controlling means 70 controls drive of the pump 532, the strength of driving force of the fan 552 of the condensing means 550, and "flow channel safety valves and cooling liquid container pressure safety valves" according to the input information so as not to interfere with the cooling operation. When the temperature of the surface to be cooled is rapidly raised (it is considered that the temperature of the surface to be cooled is too raised to burn out the surface to be cooled), the power source of the object to be cooled is shut off.

According to the present invention, the limitation of cooling in the conventional "boil cooling utilizing the nucleate boiling region" can be greatly improved by the cooling by microbubble emission boiling, and silent cooling free of noise and vibration can be realized. The boil cooling apparatus according to the present invention can be said to be a technique applicable to heat-transfer members in a wide variety of technical fields and developable to environmental resistance and energy saving.

No particular limitation is imposed on the fields of techniques and products (hereinafter referred to as products), in which the boil cooling apparatus according to the present invention is used so far as "they generate heat during operation and comprise a cooling means for cooling this heat as a composing element".

For example, a product can be provided as the construction that an electronic equipment having a heat-generating body, such as a personal computer, a fuel cell having a heat-generating body, a high heat-generating density electronic equipment, a power conversion inverter of a hybrid car, electric automobile, fuel cell-operated automobile or fuel cell-operated power generation facility, a power conversion inverter of a power system of a railway electric car or airplane, or an electronic equipment comprising a plurality of electronic devices including a power-controlled electronic package and a heat-transfer member (for example, a heat spreader) as main composing elements is installed, and the boil cooling apparatus of the present invention is integrally formed by using a surface of the heat-transfer member as "the tubular wall of the tubular flow channel of the flow channel structure".

IGBT using a Si substrate, which is widely used at present, tends to increase a heat-generating density as the output thereof is made high, and the cooling apparatus and cooling method of the present invention are extremely effective for cooling of such an electronic device.

More specifically, in an electronic equipment having a heat-generating body, such as a personal computer or a fuel cell having a heat-generating body, the boil cooling apparatus according to the present invention can be provided as a product by integrally forming a main flow channel of the flow channel structure with a surface of the heat-generating body.

As such an electronic equipment, is generally used a high heat-generating density electronic equipment, and high electric power of, for example, 50 kW or more is taken, so that it is considered that the quantity of heat generated per unit area is increased, and the heat-generating density comes to 100 W/cm² or more, further 300 W/cm². However, the boil cooling method and apparatus according to the present invention are also suitable for cooling of such an electronic equipment.

On the other hand, the flow channel structure according to the present invention and the boil cooling apparatus equipped with this flow channel structure as a composing element may also be handled as individual products.

When the flow channel structure is handled as the single product to arrange it as a composing element in the boil cooling apparatus, the length of a pipeline or the like can be adjusted according to the size of an object to be cooled, an optimum installation place of a radiator and space allowance. However, it is necessary to pour a cooling liquid in such a manner that air is not mixed in when a cooling system including a radiator, a liquid pump and the like is assembled, since no cooling liquid is contained.

When the boil cooling apparatus is handled as the single product, the construction that a cooling liquid is stored in advance in a cooling liquid container and the construction that no cooling liquid is stored may be provided as products. However, the construction that the cooling liquid is stored in advance in the cooling liquid container can omit operations of pouring the cooling liquid and removing air because the product can be handled in the state that the cooling liquid has been charged in advance.

As described above, according to the present invention, there can be provided boil cooling methods and apparatus, flow channel structures and applied products, which have heretofore been available. Since the cooling by microbubble emission boiling is conducted in the boil cooling methods of the present invention, good boil cooling can be realized even in "an unstable region that becomes transition boiling according to a conventional boil cooling method", and vibration and noise characteristic of the cooling by microbubble emission boiling can be extremely effectively lightened, so that vibration and noise of the boil cooling apparatus and applied products equipped with this apparatus can be effectively reduced by 60% or more. The lowering of heat flux on the downstream side of the cooling liquid can also be effectively lightened or prevented.

### BRIEF DESCRIPTION OF THE DRAWINGS

[FIG. 1] diagrammatically illustrates cooling by microbubble emission boiling.
[FIG. 2] is a diagram for easily understanding and explaining the concept illustrating of FIG. 1(A) in detail.
[FIG. 3] illustrates characteristic parts of a flow channel structure according to an embodiment of the present invention.
[FIG. 4] illustrates a principle of the present invention.
[FIG. 5] illustrates characteristic parts of modifications of the flow channel structure.
[FIG. 6] illustrates a boil cooling apparatus according to an embodiment of the present invention.
[FIG. 7] illustrates a control system of the apparatus in FIG. 6.
[FIG. 8] is a conceptual view of a laboratory equipment.
[FIG. 9] is a typical cross-sectional view illustrating an exemplary flow channel structure used in the laboratory equipment.
[FIG. 10] is a typical cross-sectional view illustrating a flow channel structure according to an embodiment of the present invention.
[FIG. 11] illustrates a graph for comparing heat removal heat flux and momentary pressure fluctuation showing the results of Experimental Example 1.
[FIG. 12] is a diagram in which a heat flux and a superheating degree at an end portion of an upstream side of a flow channel of a cooling liquid are plotted.
[FIG. 13] is a diagram in which a heat flux and a superheating degree at an end portion of a downstream side of the flow channel of the cooling liquid are plotted.
[FIG. 14] diagrammatically illustrates pressure fluctuation in the case where no arrangement of a group of rigid needles is used in the flow channel structure used in the laboratory equipment.
[FIG. 15] diagrammatically illustrates pressure fluctuation in the case where arrangement of a group of rigid needles is used in the flow channel structure used in the laboratory equipment.
[FIG. 16] illustrates high-speed photographs of bubble-collapsed states.
[FIG. 17] illustrates graphs for comparing heat removal heat flux and momentary pressure fluctuation according to a difference in the flow rate of a cooling liquid.
[FIG. 18] illustrates graphs for comparing heat
removal heat flux and momentary pressure fluctuation according to a difference in the subcooling degree of a cooling liquid.
[FIG. 19] is a typical cross-sectional view illustrating a flow channel structure according to an embodiment of the present invention.

### DESCRIPTION OF CHARACTERS

10 Controller
10A Surface to be cooled (heat-transfer surface)
12A Flow channel member making up a part of a flow channel structure
16 Tubular flow channel
Ni Rigid needles forming a group of rigid needles

### BEST MODE FOR CARRYING OUT THE INVENTION

### <Description of laboratory equipment>

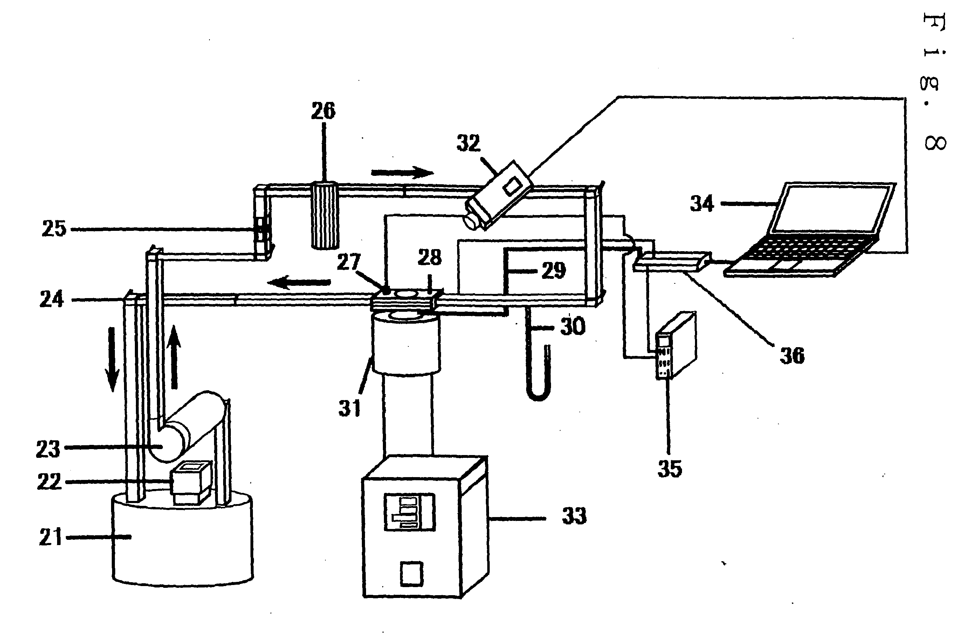

FIG. 8 is a conceptual view of a laboratory equipment.

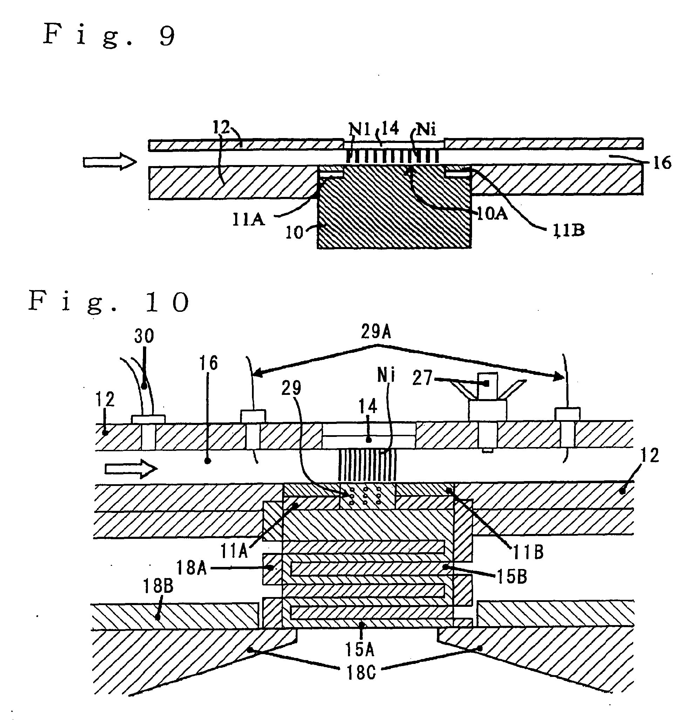

In order to prove the effect of a flow channel structure according to the present invention, the laboratory equipment illustrated in FIG. 8 is provided to conduct an experiment by installing a flow channel structure (that is substantially the same as that illustrated in FIG. 9 and specifically indicates a constructional example of a high heat-generating body) illustrated in FIG. 10 in a test part 28.

Respective parts making up the laboratory equipment are as follows, but the description of the functions thereof is omitted.

In FIG. 8, character 21 indicates a thermostatic chamber, 22 an automatic temperature controller, 23 a pump, 24 a flow control valve, 25 a flowmeter, 26 a filter, 27 a pressure sensor, 28 a test part, 29 a thermocouple, 30 a manometer, 31 an electric oven, 32 a high-speed video camera, 33 an electric oven controller, 34 a dater recording PC, 35 a direct current amplifier for pressure sensor, and 36 an AD converter.

In FIG. 10, character 29A indicates a thermocouple tap, and 18A, 18B and 18C heat insulating materials. An arrow in FIG. 10 indicates a cooling liquid, and the flow direction of the cooling liquid is indicated by the direction of the arrow.

### <Experimental Example 1>

FIG. 9 and FIG. 10 are typical cross-sectional views of flow channel structures according to the present invention. The present inventors made a flow channel structure on the basis of these typical views to prove the vibration and noise-inhibiting effect by the group of rigid needles.

The experiment using this flow channel structure is based on finding a temperature of a heat-transfer surface and a heat removal heat flux from a temperature distribution and a temperature gradient of a thermocouple embedded in a pair of rectangular heat-transfer blocks.

This flow channel structure will be first described.

In FIG. 9, character 10 indicates a high heat-generating body that is "an object to be cooled". The high heat-generating body 10 was made of copper, a peripheral portion of an upper flat surface thereof was cut out, a heat insulating material 11A and heat-resistant silicon 11B were provided at this portion, and the remaining portion was used as a surface 10A to be cooled (also referred to as a heat-transfer surface). The size of the surface 10A to be cooled is 50 mm in a lateral direction of the drawing, which is a flow direction of a cooling liquid, and 20 mm in a width direction that is a direction perpendicular to the drawing.

The specific construction of this high heat-generating body 10 is as illustrated in FIG. 10, and characters 15A and 15B indicate a copper block and a cartridge heater (heat-generating body), respectively.

A member 12 making up a tubular flow channel is composed of stainless steel, "a sectional form perpendicular to the flow direction of the cooling liquid" of the tubular flow channel 16 is a rectangular form having a height of 50 mm in a vertical direction of the drawing and a width of 24 mm in a direction perpendicular to the drawing, and the length in the flow direction is 500 mm.

A part of a lower portion of the flow channel member 12 was cut out, and an upper portion of the high heat-generating body 10 was tightly fitted in the cut-out portion in such a manner that the surface 10A to be cooled becomes the same plane as the tubular wall of the tubular flow channel 16.

On the other hand, "a portion opposing to the surface to be cooled" in an upper portion of the flow channel member 12 was cut out, and a transparent acrylic plate 14 was fitted in this portion to form "a window for observation". An inner surface of this acrylic plate 14 forms a part of the tubular wall of the tubular flow channel and is provided with a group of rigid needles represented by N1, N2, ··· Ni ·· in advance.

As the individual rigid needles Ni, were used stainless steel needles each having a circular sectional form of 1.0 mm in diameter and a length of a little over 5 mm, and the tip ends of the rigid needles Ni were heated and pressed into a flow channel-side surface (tubular wall) of the acrylic plate and then cooled to fix them in such a manner that the tip ends thereof protrude within the flow channel and approach to the surface 10A to be cooled with a slight space without coming into contact with the surface to be cooled, and the protruded length becomes a little under 5 mm.

Eleven rigid needles Ni were linearly arranged at intervals of 5 mm in the flow direction, and this arrangement is regarded as a row, and 8 flow channel structure samples in total of those, in which the number of rows arranged in a width direction was changed from 1 row to 7 rows, and that having no group of rigid needles were provided.

Incidentally, with respect to the arrangement of the groups of rigid needles in the width direction (direction perpendicular to the drawing) of the flow channel, an interval between the rows is unified to 3.3 mm in all the 6 samples excluding the sample that the group of rigid needles is only one row. With respect to the samples that the number of groups of rigid needles were 1, 3, 5 and 7 rows, the rigid needles are arranged in such a manner that the row of the central group of rigid needles conforms to a center line of the surface 10A to be cooled in the flow direction, and with respect to the samples that the number of groups of rigid needles were 2, 4 and 6 rows, the rigid needles are evenly arranged on the basis of the center line.

As "the cooling liquid", was used "pure water" subcooled to a subcooling degree of 40 K (liquid temperature: 60°C), a pressure on an inlet side (left side in FIG. 9) was controlled to about 1.1 atm, a pressure on an outlet side was controlled to about 1 atm, and a mean flow rate was controlled to 0.5 m/sec.

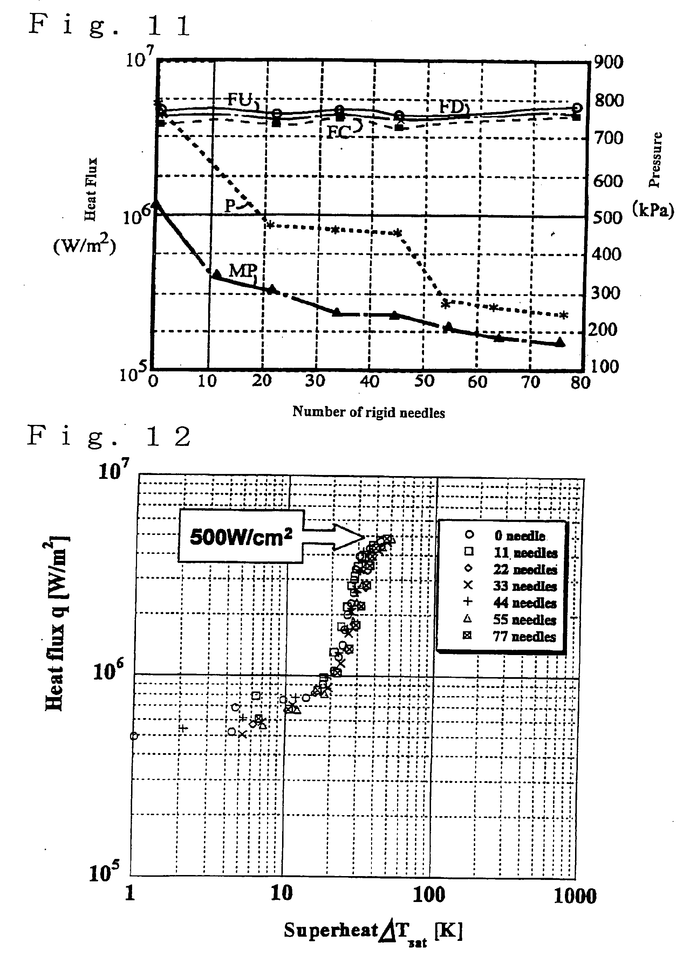

The above-described 7 flow channel structure samples were used, and the number of the rigid needles arranged was changed as a parameter to determine "heat flux" at 3 places of an end portion (place 5 mm away from the end) of an upstream side of the flowing of the cooling liquid on the surface 10A to be cooled, a central portion and an end portion (place 5 mm away from the end) of a downstream side, and a maximum momentary pressure and a mean pressure in pressure fluctuation within the tubular flow channel. The results are shown in FIG. 11.

In FIG. 11, an axis of ordinate on the left side indicates "heat flux", an axis of ordinate on the right side indicates "pressure", and an axis of abscissa indicates the number of rigid needles arranged.

With respect to each of the samples that the rigid needles were arranged in M = 1 (11 needles), M = 2 (22 needles), M = 3 (33 needles), M = 4 (44 needles), M = 5 (55 needles), and M = 7 (77 needles), in which M indicates the number of rows of rigid needles, the heat flux, maximum momentary pressure and mean pressure were measured (a semiconductor pressure converter manufactured by Toyoda Machine Works was used as a manometer).

A graphic curve FU indicates a heat flux at "the end portion of the upstream side in the flow direction of the cooling liquid" on the surface 10A to be cooled, a graphic curve FC indicates a heat flux at "the central portion in the flow direction of the cooling liquid" on the surface 10A to be cooled, and a graphic curve FD indicates a heat flux at "the end portion of the downstream side in the flow direction of the cooling liquid" on the surface 10A to be cooled.

As apparent from the conditions of these graphic curves FU, FC and FD, it is known that the heat fluxes obtained retain 400 to 500 W/cm² (4 to 5 MW (megawatt)/m²) and do not vary according to the position of the flow channel of the cooling liquid of the surface to be cooled, the number of rows of the rigid needles making up the groups of rigid needles does substantially not affect the heat flux, and the above heat fluxes are obtained irrespective of the presence of the group of rigid needles.

On the other hand, in FIG. 11, a graphic curve P indicates "maximum momentary pressure in pressure fluctuation" within the tubular flow channel 16, and a graphic curve MP indicates "mean pressure in pressure fluctuation" within the tubular flow channel 16. As apparent from the graphic curves P and MP, both maximum momentary pressure and mean pressure are rapidly reduced as the number of rows of the rigid needles making up the groups of rigid needles increases.

"The mean pressure" is a mean of fluctuating momentary pressures. FIG. 11 indicates that "a fluctuating momentary pressure" is high as the number or rigid needles is small. The cause of noise and vibration is "a momentary pressure", and the reduction of the mean pressure means that the fluctuating momentary pressure is lowered.

For example, even when the row of the group of rigid needles is one (M = 1, the number of rigid needles: 11), the maximum momentary pressure P is reduced to about 80% of the maximum momentary pressure of the case where no group of rigid needles is provided. When the number of the rigid needles arranged falls within a range of 22 (M = 2) to 44 (M = 4), the maximum momentary pressure P is reduced to about 60% of the maximum momentary pressure (about 800 kPa) of the case where no group of rigid needles is provided. When the number of the rigid needles arranged falls within a range of 55 (M = 5) to 77 (M = 7), the maximum momentary pressure P is reduced to 250 kPa or lower (about 30% or lower of the maximum momentary pressure of the case where no group of rigid needles is provided, and it was known that a pressure-reducing effect of about 70% or higher is achieved.

The mean pressure MP is reduced to about 45% of the mean pressure (about 510 kPa) of the case where no group of rigid needles is provided when M falls within a range of 2 to 4. When M falls within a range of 5 to 7, the mean pressure is reduced to about 35% or lower of the mean pressure of the case where no group of rigid needles is provided.

Then, 3 thermocouples were arranged under the surface 10A to be cooled in the laboratory equipment to calculate out a heat flux and a superheating degree from temperature gradients measured by these thermocouples.

In general, the superheating degree is represented by [Superheating degree = (temperature of the surface to be cooled) - (saturation temperature of liquid)], and liquids different in saturation temperature are also commonly represented.

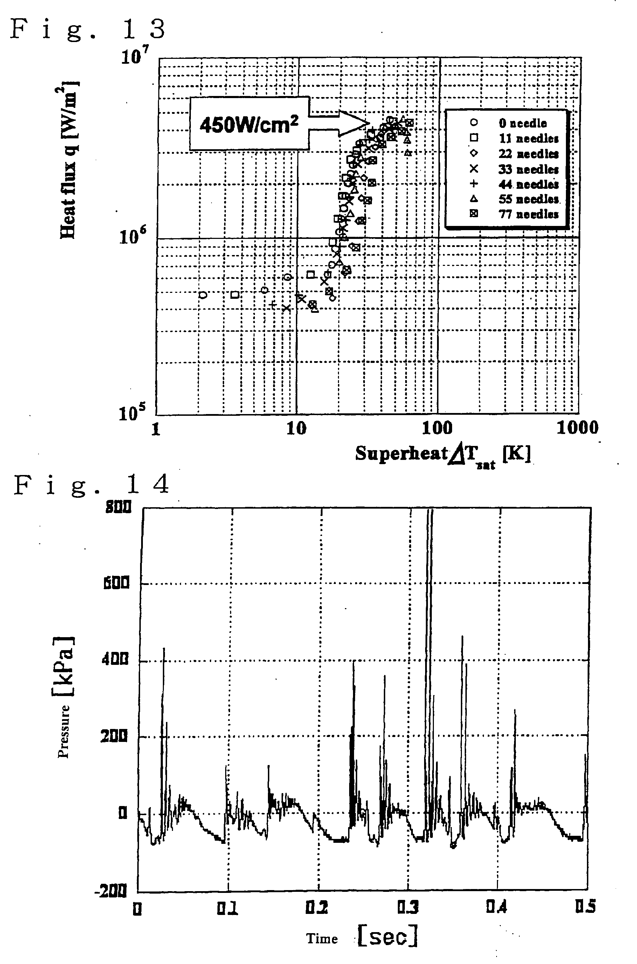

FIG. 12 and FIG. 13 are diagrams in which a heat flux and a superheating degree are plotted as to end portions of an upstream side and a downstream side, respectively, of a flow channel of a cooling liquid.

In these diagrams, "Superheat ΔTₛₐₜ" on an axis of abscissa and "Heat flux q" on an axis of ordinate indicate "superheating degree" and "heat flux", respectively. In the drawings, "0 needle to 77 needles" indicates the number (0 to 77; M = 0 (no group of rigid needles) to M = 7) of needles in the group of rigid needles. As described above, the subcooling degree is 40 K, and the flow rate of the cooling liquid is 0.5 m/sec.

It is apparent from FIG. 12 and FIG. 13 that "the heat flux has no relation to the number of rigid needles" on both end portions of the upstream side and the downstream side of the flow channel of the cooling liquid.

FIG. 14 illustrates "pressure change with time" in the case where no group of rigid needles is provided. As illustrated in FIG. 14, a high pressure is repeatedly generated at "an indeterminate period" of 1 second or shorter, and a maximum pressure exceeds 800 kPa.

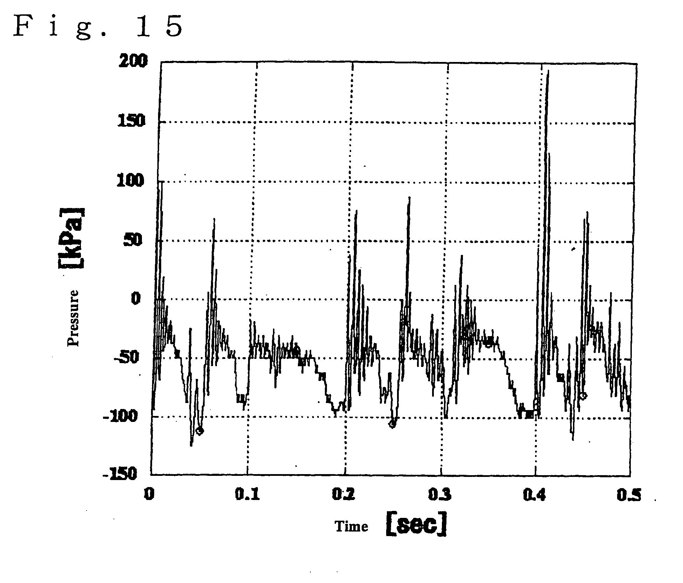

FIG. 15 illustrates "pressure change with time" in the case where 77 rigid needles are provided. As illustrated in FIG. 15, a high pressure is repeatedly generated at an indeterminate period of 1 second or shorter, but it is understood that a maximum pressure does not exceed 200 kPa.

The condition of the cooling liquid was taken by a high-speed motion picture CCD camera from the observation window 14 and observed.

As a result, bubble gradually grew when no group of rigid needles was provided, and large coalesced bubbles coalesced then started to be collapsed from the upstream side, and soon went out of sight. However, it was observed that when 77 rigid needles are provided, the bubbles grow, but the coalesced bubbles remain considerably small.

In the microbubble emission boiling according to the present invention, it is difficult to precisely confirm the condition of collapse of bubbles because the collapse of the bubbles occurs at an extremely high speed. According to the CCD camera, however, the growth of the bubbles is observed as if it is divided within the respective lattices of the groups of rigid needles. From this fact, it is considered that the bubbles are collapsed within the respective lattices, and a maximum momentary pressure generated up the collapse of the bubbles is extremely low compared with a maximum momentary pressure generated upon the collapse of the large bubbles when no group of rigid needles is provided.

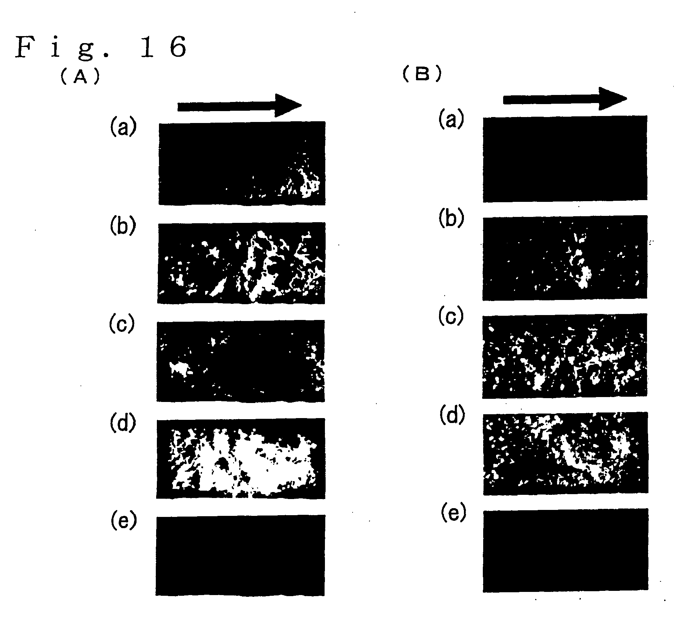

FIG. 16 illustrates high-speed photographs (7,000 frames/sec) of changes in bubbles from generation of bubbles to collapse thereof. In FIG. 16, (a), (b), (c), (d) and (e) indicate states upon the generation of boiling bubbles (0 msec), upon the growth and coalescing of the bubbles (14.1 msec), upon just before the collapse of the bubbles (28.2 msec), upon the collapse of the bubbles (42.3 msec) and upon supply of the cooling liquid (56.4 msec), respectively. The arrow indicates a flow direction of the cooling liquid.

As illustrated in FIG. 16(B), it is observed that when 77 rigid needles are arranged, the coalesced bubble is divided into small bubbles by the group of rigid needles and collapsed. As illustrated in FIG. 16(A), however, it is observed that in the case of the surface to be cooled using no rigid needle, a large coalesced bubble is collapsed at a time unlike the case where the groups of rigid needles are provided.

### <Experimental Example 2>

An experiment of microbubble emission boiling was conducted under the same conditions as in Experimental Example 1 except that the mean flow rate was changed to 0.3 m/sec, the same 5 flow channel structures as those used in Experimental Example 1 of the flow channel structure having no group of rigid needles and those, in which the number (M) of rows of the group of rigid needles are 1, 3, 5 and 7, were used.

As a result, it was confirmed that even when the row of rigid needles is increased, the maximum heat flux retains a value within a range of about 350 to 450 W/cm² and does not vary according to the number of rigid needles.

On the other hand, the pressure generated by collapse of the coalesced bubble is reduced as the row of rigid needles is increased, and the maximum momentary pressure P is reduced to about 310 kPa (77%) when the group of rigid needles is provided in a row compared with about 400 kPa when no group of rigid needles is provided, and sequentially reduced to about 270 kPa (67%) in 3 rows and about 210 kPa (52%) in 5 rows. When the group of rigid needles is increased to 7 rows, the maximum momentary pressure is reduced to about 160 kPa (40%), and it was known that a pressure-reducing effect of about 60% is achieved.

When the group of rigid needles is increased to 7 rows, the mean pressure MP was reduced to about 70 kPa (56%) compared with about 125 kPa when no group of rigid needles is provided.

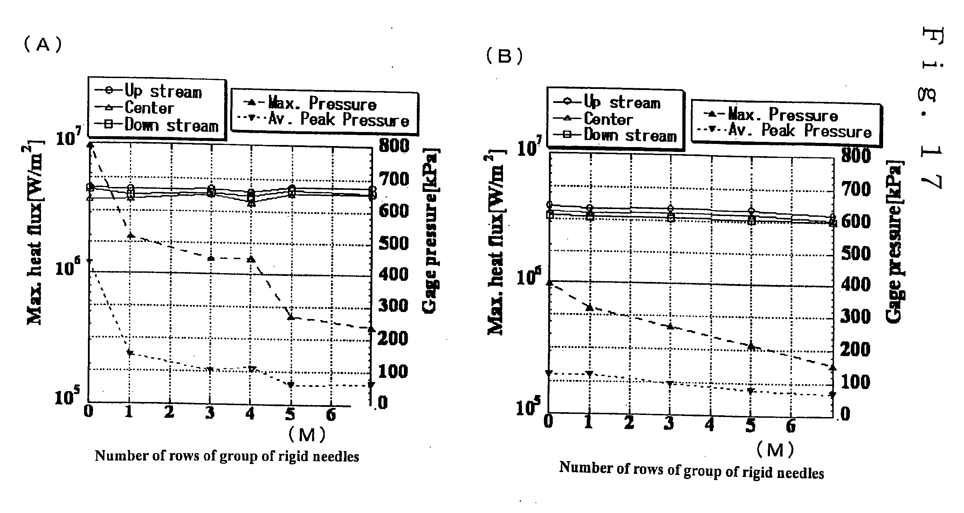

However, it is apparent from FIG. 17 that when compared with Experimental Example 1, both heat removal heat flux and momentary pressure become low even when no group of rigid needles is provided as the mean flow rate of the cooling liquid becomes low, but the rate of pressure reduction within the flow channel attending on increase in the number (number of needles) of rows of the group of rigid needles is also reduced.

In other words, FIG. 17 is shown for comparing heat removal heat flux and momentary pressure between the case (B) where the mean flow rate was set to 0.3 m/sec and the case (A) [the same as FIG. 11] where the mean flow rate was set to 0.5 m/sec.

### <Experimental Example 3>

An experiment of microbubble emission boiling was conducted under the same conditions as in Experimental Example 1 except that the cooling liquid was changed to a cooling liquid having a subcooling degree of 20 K, the same 5 flow channel structures as those used in Experimental Example 1 of the flow channel structure having no group of rigid needles and those, in which the number (M) of rows of the group of rigid needles are 1, 3, 5 and 7, were used.

As a result, it was confirmed that even when the row of rigid needles is increased, the maximum heat flux retains a value within a range of about 300 to 400 W/cm² and does not vary according to the number of rigid needles.

On the other hand, with respect to the pressure generated by collapse of the coalesced bubble, the maximum momentary pressure P is reduced to about 190 kPa (50%) when the group of rigid needles is provided in a row compared with about 380 kPa when no group of rigid needles is provided, and reduced to about 160 kPa (47%) in 3 rows and 5 rows. When the group of rigid needles is increased to 7 rows, the maximum momentary pressure is reduced to about 160 kPa (40%), and it was known that a pressure-reducing effect of about 60% is achieved.

When the group of rigid needles is increased to 7 rows, the mean pressure MP was reduced to about 45 kPa (33%) compared with about 135 kPa when no group of rigid needles is provided.

However, when compared with Experimental Example 1, both heat removal heat flux and momentary pressure become greatly low even when no group of rigid needles is provided as the subcooling degree of the cooling liquid becomes low, but the rate of pressure reduction within the flow channel attending on increase in the number (number of needles) of rows of the group of rigid needles is also reduced, and so it is hard to achieve stable boil cooling great in the vibration and noise-inhibiting effect and high in cooling efficiency.

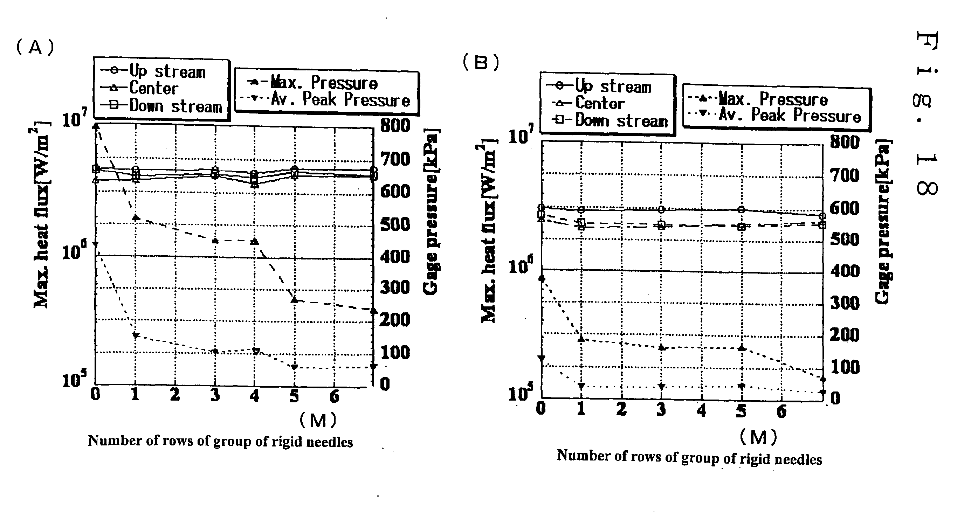

FIG. 18 is shown for comparing heat removal heat flux and momentary pressure between the case (B) where the subcooling degree was 20 K and the case (A) [the same as FIG. 11] where the subcooling degree was 40 K.

### <Experimental Example 4>

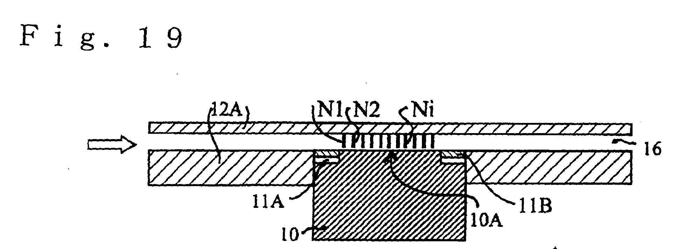

Experimental Example 4 was performed by using a flow channel structure illustrated in FIG. 19.

This flow channel structure is the same as the flow channel structure used in Experimental Example 1 and illustrated in FIG. 9 except that cutting out of the portion where "the portion opposing to the surface to be cooled" in the upper portion of the flow channel member 12 was cut out, and the transparent acrylic plate 14 was fitted in this portion to form "the window for observation" was not conducted for providing "the window for observation", and the groups of rigid needles were fixed by brazing. An arrow in FIG. 19 indicates a cooling liquid, and the flow direction of the cooling liquid is indicated by the direction of the arrow.

This flow channel structure was used to conduct an experiment of microbubble emission boiling under the same conditions as in Experimental Example 1. As a result, the maximum heat flux within a range of about 400 to 500 W/cm² was retained. On the other hand, the maximum momentary pressure P was reduced to a pressure maximum value of 250 kPa or lower (50% compared with the case where no group of rigid needles is provided) when the group of rigid needles was provided in 7 rows, a pressure-reducing effect of about 70% was achieved, and vibration and noise were at "a level having no regard".

## Claims

1. A boil cooling method, comprising using a surface of an object to be cooled or a surface of a heat-transfer member coming into close contact with the surface of the object to be cooled as a surface to be cooled, providing the surface to be cooled within a tubular flow channel, causing a subcooled cooling liquid to flow through the tubular flow channel, growing bubbles generated by boiling of the cooling liquid on the surface to be cooled, which is heated, up to a critical heat flux, and condensing and collapsing a coalesced bubble formed in a contacted state on the surface to be cooled by the cooling liquid to make high heat flux heat removal, wherein at least part of a group of fine-diameter rigid needles provided in and fixed to the tubular flow channel are brought to a state entered into the coalesced bubble, thereby reducing a pressure generated upon the collapse of the coalesced bubble.

2. The boil cooling method according to claim 1, wherein the mean flow rate of the cooling liquid is 0.2 to 1.0 m/sec.

3. The boil cooling method according to claim 1 or 2, wherein the subcooling degree of the cooling liquid at 1 atm is 20 K or higher.

4. The boil cooling method according to any one of claims 1 to 3, wherein the cooling liquid is water, alcohol, a mixture of water and alcohol, or a fluorine-containing inert liquid.

5. The boil cooling method according to any one of claims 1 to 3, wherein the cooling liquid is an antifreezing fluid.

6. The boil cooling method according to any one of claims 1 to 5, wherein the cooling liquid is caused to flow through the tubular flow channel in such a manner that the quantity of air within the flow channel is controlled to 0 to 20%.

7. The boil cooling method according to any one of claims 1 to 6, wherein an ultrasonic wave is applied from an outer surface of the tubular flow channel, which is opposed to an inner wall portion to which the group of rigid needles is fixed.

8. The boil cooling method according to any one of claims 1 to 7, wherein a structure that a tubular secondary flow channel is formed separating from the flow channel, through which the cooling liquid is caused to flow, by a partition wall, and plural fine tubular supply parts for supplying the cooling liquid into the tubular flow channel through the partition wall from the secondary flow channel are provided is used as a flow channel structure to supply the cooling liquid to the tubular flow channel and the secondary flow channel in the flow channel structure, thereby causing the cooling liquid to flow through both flow channels to conduct cooling together with the cooling liquid in the tubular flow channel that is a main flow channel while supplying the cooling liquid to the tubular flow channel from the secondary flow channel side.

9. A boil cooling apparatus, comprising a tubular flow channel, through which a subcooled cooling liquid is caused to flow, and which is provided with a surface to be cooled, wherein a surface of an object to be cooled or a surface of a heat-transfer member coming into close contact with the surface of the object to be cooled is used as the surface to be cooled, bubbles generated by boiling of the subcooled cooling liquid on the surface to be cooled, which is heated, are grown up to a critical heat flux, and a coalesced bubble formed in a contacted state on the surface to be cooled is condensed and collapsed by the cooling liquid to make high heat flux heat removal, and wherein the tubular flow channel is a flow channel structure having a group of fine-diameter rigid needles provided in and fixed to the tubular flow channel, at least part of which are entered into the coalesced bubble.

10. The boil cooling apparatus according to claim 9, wherein a flow channel structure that the surface to be cooled and a tubular inner wall of the tubular flow channel opposing to this surface are parallel to each other, and the group of rigid needles is fixed to an inner wall portion opposing to the surface to be cooled and provided protrudently toward the surface to be cooled is used.

11. The boil cooling apparatus according to claim 9 or 10, wherein a flow channel structure that the group of rigid needles is provided in at least a row in a flow direction of the tubular flow channel is used.

12. The boil cooling apparatus according to claim 11, wherein the group of rigid needles is provided in at least two rows, and an interval between the rigid needles in a width direction perpendicular to the flow direction is 2 to 5 mm.

13. The boil cooling apparatus according to any one of claims 9 to 12, wherein a flow channel structure that the length of the surface to be cooled in the flow direction of the tubular flow channel is 1 to 5 cm is used.

14. The boil cooling apparatus according to any one of claims 9 to 13, wherein a flow channel structure that the surface to be cooled forms at least a part of the tubular inner wall of the tubular flow channel is used.

15. The boil cooling apparatus according to any one of claims 9 to 14, wherein a flow channel structure that the group of rigid needles is formed in such a manner that the tip ends of the rigid needles approach to the surface to be cooled with an interval of 0.5 mm or less is used.

16. The boil cooling apparatus according to any one of claims 9 to 15, wherein a flow channel structure that a material forming at least a surface of the object to be cooled or the heat-transfer member coming into close contact with the object to be cooled is ultra-hydrophilic is used.

17. The boil cooling apparatus according to any one of claims 9 to 16, wherein a flow channel structure that a tubular secondary flow channel is formed separating from the tubular flow channel, through which the cooling liquid is caused to flow, by a partition wall, and a plurality of fine tubular supply parts for supplying the cooling liquid into the tubular flow channel through the partition wall from the secondary flow channel are provided is used.

18. The boil cooling apparatus according to any one of claims 9 to 17, wherein a plurality of the flow channel structures is provided closely and in parallel to each other.

19. The boil cooling apparatus according to any one of claims 9 to 18, which is equipped with a cooling liquid-supplying and flowing means for supplying the cooling liquid to the tubular flow channel to cause it to flow.

20. The boil cooling apparatus according to claim 19, wherein the cooling liquid-supplying and flowing means has a cooling liquid container for storing the cooling liquid.

21. The boil cooling apparatus according to claim 20, wherein the cooling liquid is stored in the cooling liquid container.

22. The boil cooling apparatus according to any one of claims 19 to 21, wherein the cooling liquid-supplying and flowing means has a convection type heat radiating means, and the heat radiating means cools the cooling liquid flowed through the flow channel structure and contributed to the cooling of the surface to be cooled.

23. The boil cooling apparatus according to claim 22, wherein the convection type heat radiating means is an air-cooled radiator.

24. A flow channel structure used in the boil cooling apparatus according to any one of claims 9 to 23.

25. A product that generates heat during operation and comprises a cooling means for the heat as a composing element, wherein the boil cooling apparatus according to any one of claims 9 to 23 is used as the cooling means.

26. The product according to claim 25, which is an electronic device package having a heat-generating body, wherein the tubular flow channel of the flow channel structure making up the boil cooling apparatus is integrally formed by using a surface of the heat-generating body as a tubular inner wall.

27. The product according to claim 25, which is a power conversion-controlling unit of a hybrid automobile, electric automobile, fuel cell-operated automobile or fuel cell-operated power generation facility, or a power conversion-controlling unit of a power system for a computer or supercomputer, or a railway electric car or airplane, in which a high heat-generating density electronic equipment comprising an electronic device and a heat-transfer member as main composing elements is installed, and wherein the tubular flow channel of the flow channel structure making up the boil cooling apparatus is formed by using a surface of the heat-transfer member as a tubular inner wall.

28. A boil cooling method, comprising using a surface of an object to be cooled or a surface of a heat-transfer member coming into close contact with the surface of the object to be cooled as a surface to be cooled, providing the surface to be cooled within a tubular flow channel, causing a subcooled cooling liquid to flow through the tubular flow channel, growing bubbles generated by boiling of the cooling liquid on the surface to be cooled, which is heated, up to a critical heat flux, and condensing and collapsing a coalesced bubble formed in a contacted state on the surface to be cooled by the cooling liquid to make high heat flux heat removal, wherein at least part of plural convex members provided in and fixed to the tubular flow channel are brought to a state entered into the coalesced bubble, thereby reducing a pressure generated upon collapse of the coalesced bubble.

29. A boil cooling apparatus, comprising a tubular flow channel, through which a subcooled cooling liquid is caused to flow, and which is provided with a surface to be cooled, wherein a surface of an object to be cooled or a surface of a heat-transfer member coming into close contact with the surface of the object to be cooled is used as the surface to be cooled, bubbles generated by boiling of the subcooled cooling liquid on the surface to be cooled, which is heated, are grown up to a critical heat flux, and a coalesced bubble formed in a contacted state on the surface to be cooled is condensed and collapsed by the cooling liquid to make high heat flux heat removal, and wherein the tubular flow channel is a flow channel structure having plural convex members provided in and fixed to the tubular flow channel, at least part of which are entered into the coalesced bubble.
